# FASCICULE DE BREVET EUROPEEN

(11) **EP 2 410 767 B1**
(45) Date de publication et mention de la délivrance du brevet: **24.08.2016**
(21) Numéro de dépôt: 11174608.7
(22) Date de dépôt: 20.07.2011
(51) Int. Cl.: H04R 9/08, H04R 11/04, H04R 19/00, H04R 19/04

(54) **Capteur de pression dynamique mems, en particulier pour des applications à la réalisation de microphones**
Dynamischer MEMS-Drucksensor, insbesondere für Anwendungen im Zusammenhang mit der Herstellung von Mikrophonen
MEMS dynamic pressure sensor, in particular for microphone-making applications

(30) Priorité: 22.07.2010 FR 1056002
(43) Date de publication de la demande: 25.01.2012
(73) Titulaire: Commissariat à l'Énergie Atomique et aux Énergies Alternatives, 75015 Paris (FR)
(72) Inventeur: ROBERT, Philippe, 38000 GRENOBLE (FR); WALTHER, Arnaud, 38000 GRENOBLE (FR)
(74) Mandataire: Ilgart, Jean-Christophe

(56) Documents cités:
- EP-A2- 1 978 779
- WO-A1-93/19561
- WO-A1-94/14240
- WO-A2-2005/031299
- DE-A1-102005 008 511
- GB-A- 2 218 303
- JP-A- 58 050 895
- US-A1- 2002 009 202
- US-A1- 2005 052 723
- MATTHIAS WINTER ET AL: "Influence of a chip scale package on the frequency response of a MEMS microphone", MICROSYSTEM TECHNOLOGIES ; MICRO AND NANOSYSTEMS INFORMATION STORAGE AND PROCESSING SYSTEMS, SPRINGER, BERLIN, DE, vol. 16, no. 5, 25 décembre 2009 (2009-12-25), pages 809-815, XP019804454, ISSN: 1432-1858
- PETERSEN K ET AL: "Resonant beam pressure sensor fabricated with silicon fusion bonding", TRANSDUCERS. SAN FRANCISCO, JUNE 24 - 27, 1991; [PROCEEDINGS OF THE INTERNATIONAL CONFERENCE ON SOLID STATE SENSORS AND ACTUATORS], NEW YORK, IEEE, US, vol. CONF. 6, 24 juin 1991 (1991-06-24), pages 664-667, XP010037438, DOI: DOI:10.1109/SENSOR.1991.148968 ISBN: 978-0-87942-585-2

## Description

### DOMAINE TECHNIQUE ET ART ANTÉRIEUR

L'invention concerne le domaine des micro-capteur MEMS ou des capteurs dynamiques MEMS, en particulier pour la réalisation de microphones ou de capteurs de pression, notamment de type relatif.

Les microphones MEMS sont de plus en plus présents dans les applications grand public (comme la téléphonie mobile, caméscope, appareil photo,...).

Ces composants utilisent généralement une membrane susceptible de se déformer en fonction de la pression exercée par le son à détecter, et des moyens de détection de cette vibration par des moyens capacitifs associés à cette membrane.

Le principe de ce capteur est expliqué dans l'article de S. Chowdhury et al. « Nonlinear Effects in MEMS Capacitive Microphone Design ». Proceedings of the International Conference on MEMS, NANO and Smart Systems (ICMENS 2003).

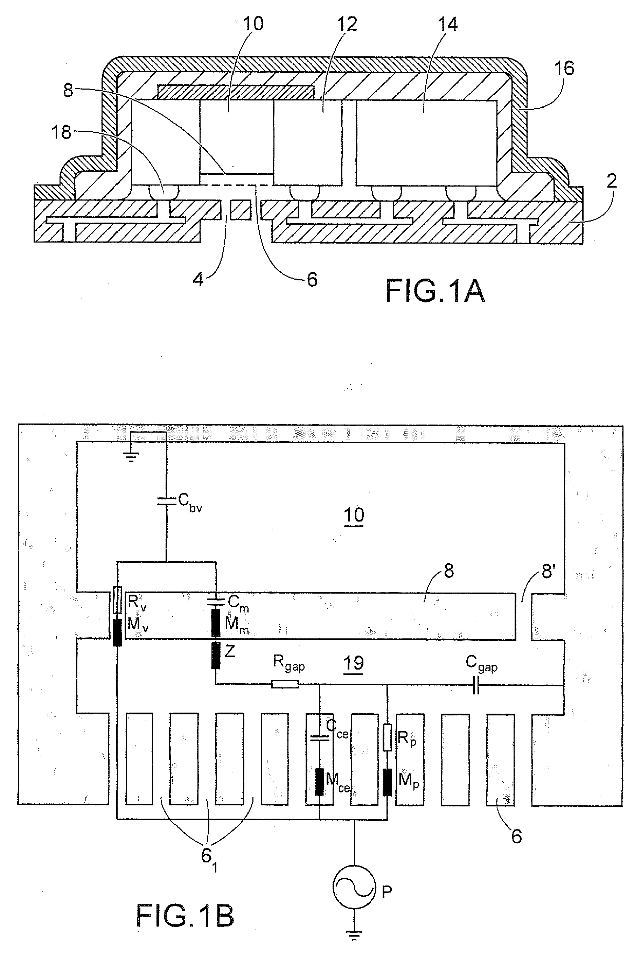

En figure 1A est représentée la structure d'un microphone 1, comme expliqué par Matthias Winter et al. dans « Influence of a chip scale package on the frequency response of a MEMS microphone » - Microsystem Technologies, Déc. 2009, DOI 10.1007/s00542-009-0994-z. Cette publication donne également le schéma électrique équivalent illustré en figure 1B.

Une puce MEMS 12 et un ASIC 14 sont fixés par des billes 18 à un substrat 2 en céramique, qui présente des trous traversant 4, permettant à l'onde de pression d'atteindre le capteur proprement dit, constitué d'une contre électrode perforée 6 et d'une membrane circulaire 8. Cette dernière comporte de petites ouvertures formant évents pour permettre une compensation de la pression statique. Derrière la membrane se trouve un espace 10 fermé par une couche de polymère et protégé par une métallisation en cuivre.

Le schéma de la figure 1B montre la résistance (acoustique) Rₚ amenée par la présence des trous 6₁ dans l'électrode fixe 6 que l'onde pression doit traverser avant de pouvoir appliquer un effort sur la membrane 8. Une seconde résistance acoustique (R_{gap}) provient de l'amortissement de la membrane 8 dû au déplacement du gap d'air 19 entre celle ci et l'électrode fixe 6. Ces deux résistances sont par conséquent à minimiser pour accroître la sensibilité du capteur.

La réduction de la résistance Rp se fait notamment en augmentant le nombre de trous 6₁ dans l'électrode fixe 6. Ces perforations peuvent atteindre près de 20% de la surface totale de l'électrode comme expliqué dans l'article de A. Dehe « Silicon microphone development and application ». - Sensor and Actuators A 1333:283-287.

Ces perforations diminuent d'autant la surface utile de la capacité de mesure, et donc la sensibilité. Un compromis doit par conséquent être trouvé.

Dans ce dernier article, l'auteur donne des dimensions caractéristiques de ces microphones.

Il y est en outre précisé que la bande passante du capteur est également fortement dépendante du dimensionnement des perforations 6₁ et du gap d'air 19.

Le gap d'air 19 et les perforations 6₁ ont également un rôle déterminant sur le bruit de ces microphones comme indiqué par M. Brauer et al. « Improved signal-to-noise ratio of Silicon microphones by a high-impedance resistor", J.Micromech. Microeng. 14 (2004) 86-89.

La demande de brevet JP58050895 propose un capteur de pression (non MEMS ou NEMS) dans lequel au moins une paroi est mobile dans le plan du capteur. Dans tous les exemples connus, on constate les problèmes suivants.

La membrane 8, qui sert à la fois de ressort mécanique et d'électrode mobile, récupère le signal acoustique, et est toujours corrélée à l'électrode 6 de détection. Il n'est par conséquent pas possible d'optimiser séparément la partie acoustique du capteur de la partie mesure électrique. Cela se caractérise notamment :
- par une perte importante de la sensibilité due à la présence de très nombreux trous dans la membrane 6, nécessaire d'un point de vue acoustique pour réduire la résistance acoustique, mais qui réduit fortement les surfaces en regard pour la détection capacitive ; on note par exemple une réduction des surface en regard pouvant allerjusqu'à près de 20%,
- par un amortissement visqueux, déterminé, entre autre, par le gap d'air 19 entre la membrane 8 et l'électrode fixe 6 de détection. Le gap est lui-même dépendant de la gamme de pression à mesurer (flexion maximale admise par la membrane) et la tension de lecture (limite de « pull-in »).

Toutes les structures connues de microphone sont basées sur l'utilisation d'une membrane souple 8 encastrée sur sa périphérie. Cela signifie que, sous l'effet d'une pression extérieure, la membrane se déforme principalement au centre, mais pratiquement pas sur sa périphérie. Par conséquent, seule une fraction de la déformation est utilisable pour la détection capacitive.

Par ailleurs, il est nécessaire d'appliquer une tension entre la membrane 8 et l'électrode 6 de lecture pour lire la variation de capacité résultant de la déformation de la membrane sous l'effet de la pression acoustique à mesurer. Pour limiter le bruit de mesure et augmenter la sensibilité de ce microphone, cette tension doit être maximisée. Or, cette maximisation est difficile à assurer car elle suppose de prendre en compte plusieurs paramètres, et notamment la taille de l'entrefer et la pression maximum à mesurer (on cherche à fonctionner au voisinage de la tension de « pull in », qui est la tension pour laquelle la membrane vient coller sur l'électrode de commande).

D'autres problèmes sont à signaler :
- les composants connus sont très sensibles aux variations de procédé de réalisation. La sensibilité du microphone est en effet très variable en fonction de l'épaisseur de la membrane et des contraintes dans le matériau,
- la réponse est non linéaire en fonction de la pression acoustique, la capacité de détection étant proportionnelle à l'inverse de la distance entre la membrane 8 électrode 6,
- la gamme de pression et la tenue aux chocs de pression sont limitées, la structure et le procédé de réalisation rendant difficile la mise en place de butées dans l'entrefer.

Il se pose donc le problème de trouver une nouvelle structure de capteur ou de micro-capteur de type MEMS ou de capteur dynamique de type MEMS ne présentant pas les inconvénients et limitations ci-dessus.

Il se pose également le problème de trouver un nouveau procédé de réalisation d'une telle structure.

### EXPOSÉ DE L'INVENTION

L'invention concerne d'abord un capteur de pression, selon la revendication 1 par exemple de type MEMS et/ou NEMS comportant :
- au moins une première cavité déformable pour recevoir des variations de pression d'une atmosphère ambiante, cette première cavité déformable étant réalisée dans au moins une première couche ou un premier substrat et comportant au moins une paroi mobile ou déformable, disposée au moins en partie dans le plan parallèle du premier substrat, dit plan du capteur, et des moyens pour transmettre à cette cavité des variations de pression d'une atmosphère ambiante,
- des moyens de détection pour détecter un déplacement ou une déformation, dans le plan du capteur, de ladite paroi mobile ou déformable, sous l'effet d'une variation de pression de l'atmosphère ambiante.

L'invention concerne donc une structure de capteur de pression ou de microphone, par exemple de type MEMS, où la paroi ou la membrane d'une cavité de détection se déplace dans le plan d'un substrat, et non hors plan comme c'est le cas dans les structures connues de l'art antérieur.

Selon l'invention, on décorrèle ainsi la partie détection, par exemple par une mesure électrique, telle qu'une mesure de type capacitif ou de type jauge de contrainte, de la paroi ou la membrane de détection, soumise à la pression acoustique. La sensibilité du capteur s'en trouve accrue par rapport à un capteur connu de l'art antérieur.

Dans un dispositif selon l'invention des variations de pression ou une onde de pression d'une atmosphère ambiante, arrivent perpendiculairement à la structure, ou au plan du capteur.

Un dispositif selon l'invention peut comporter en outre au moins une cavité secondaire, ou cavité tampon, en partie en communication avec la première cavité.

Une fonction de filtre des fluctuations rapides peut être réalisée par une perte de charge entre la cavité principale et une cavité secondaire ou « back volume ». Plus particulièrement, cette perte de charge peut résulter d'un « gap » de la poutre ou de la membrane ou de la partie mobile ou déformable mais également de la largeur de la poutre ou de la membrane ou de la partie mobile ou déformable. Le « gap » (appelé encore « entrefer ») peut être un espace fin entre la partie mobile et la partie fixe. Il se situe par exemple entre le substrat et la partie mobile ou déformable ou entre la partie mobile ou déformable et le substrat supérieur. Outre sa fonction de perte de charge, cet espace permet à la partie mobile ou déformable de se déplacer dans le plan.

Au moins une cavité secondaire peut être réalisée dans le plan d'un deuxième substrat, différent du premier substrat, ou dans le plan du premier substrat. Dans le premier cas (cavité secondaire dans le plan d'un deuxième substrat):
- ce deuxième substrat comporte en outre les moyens pour transmettre à la première cavité des variations de pression de l'atmosphère ambiante,
- ou bien ce deuxième substrat est disposé d'un côté du premier substrat, un troisième substrat étant disposé d'un autre côté du premier substrat, ce troisième substrat comportant les moyens pour transmettre à la première cavité des variations de pression de l'atmosphère ambiante.

Autrement dit, au moins une cavité secondaire, qui peut être ouverte, en particulier dans le cas où elle n'est pas réalisée dans le même substrat que les moyens permettant de transmettre à la première cavité les variations de pression de l'atmosphère ambiante, ou fermée, peut être réalisée sur le dessus ou le dessous du dispositif. Dans le cas où cette cavité secondaire se situe dans le même substrat que les moyens permettant de transmettre à la première cavité les variations de pression de l'atmosphère ambiante, cette cavité est de préférence fermée par une membrane rigide..

Les moyens de détection peuvent comporter des moyens de type capacitif ou de type jauge de contrainte.

La détection de type « jauge de contrainte » offre l'avantage d'être moins sensible à l'environnement extérieur, notamment à l'humidité, que la détection de type capacitive.

Par contre, une détection de type capacitive offre les avantages suivants :
- possibilité d'avoir une forte amplitude de déplacement de la paroi ou membrane mobile ou déformable, qui peut aller jusqu'à quelques centaines de nanomètres, par exemple jusqu'à 500 nm,
- possibilité d'avoir une grande gamme de tensions de polarisation (surtout dans le cas d'une mesure capacitive différentielle), par exemple jusqu'à 30 V.

Dans un mode de réalisation particulier, les moyens de détection comportent des moyens de type capacitif, à variation de surface, comportant au moins un premier peigne mobile dans le plan du capteur et au moins un deuxième peigne, fixe, les dents du premier peigne et celles du deuxième peigne étant alternées, et des moyens pour transmettre au premier peigne un déplacement ou une déformation, dans le plan du capteur, de ladite paroi mobile ou déformable.

Un autre mode de réalisation particulier, les moyens de détection, de type capacitif, sont à variation d'entrefer.

Dans le cas où les moyens de détection sont de type à jauges de contrainte, ils peuvent comporter en outre au moins un bras de levier mobile dans le plan du capteur, et des moyens pour transmettre à ce bras de levier et à au moins une jauge de contraintes, un déplacement ou une déformation, dans le plan du capteur, de ladite paroi mobile ou déformable, ladite jauge de contrainte permettant de détecter un déplacement du bras de levier dans le plan du capteur.

Au moins une paroi mobile ou déformable peut comporter deux extrémités latérales, et :
- être encastrée ou fixée à une de ces extrémités latérales sur une paroi fixe, et être libre à son autre extrémité,
- ou être encastrée ou fixée à ses deux extrémités latérales,
- ou être rigide, et maintenue à ses deux extrémités latérales par des éléments déformables.

Dans un dispositif selon l'invention, la fréquence de résonance de la partie mobile (la membrane ou la paroi ou le piston ou l'un de ces éléments et un ou plusieurs bras de suspension) est décorrélée du contrôle de la perte de charge (gap, profondeur du piston, ouvertures des events).

Un capteur selon l'invention peut comporter des premiers moyens de détection et des deuxièmes moyens de détection montés de manière à réaliser une mesure différentielle.

Un capteur selon l'invention peut comporter une structure différentielle, permettant de ne détecter que les variations de pression à l'intérieur de la cavité principale, mais pas des chocs ou des d'accélérations extérieures au dispositif.

Selon différents modes de réalisation, les moyens pour transmettre dans la première cavité des variations de pression d'une atmosphère ambiante peuvent comporter une ouverture unique ou une pluralité d'ouvertures disposée en regard d'une ouverture de ladite première cavité déformable ou une membrane disposée sur une ouverture de ladite première cavité déformable.

Les moyens de détections sont reliés mécaniquement à la paroi qui est mobile ou déformable dans le plan de la couche ou du substrat, mais pas disposés directement sur, ou au dessus de, celle-ci.

L'invention concerne également un dispositif de détection de variations de pression, comportant plusieurs capteurs selon l'invention, chaque capteur ayant une bande passante différente de celle de chacun des autres capteurs.

Un dispositif selon l'invention peut comporter plusieurs premières cavités déformables disposées en parallèle, au moins deux de ces cavités ayant des moyens de détection communs. Cela offre la possibilité d'augmenter la sensibilité du capteur.

L'invention permet d'associer à la paroi mobile ou déformable des éléments de détection de type peigne capacitif ou jauge de contrainte. Ceci permet de configurer et d'optimiser la cavité recevant la pression à mesurer (la raideur et/ou l'amortissement d'une plusieurs parois mobile ou déformables et/ou les dimensions de la cavité) indépendamment des moyens de détection. En particulier, la membrane et la cavité recevant la pression sont configurées indépendamment :
- des dimensions et du nombre de peignes interdigités dans le cas d'une détection capacitive,
- des dimensions de la jauge, dans le cas d'utilisation d'une jauge de contrainte (mesure de résistance dans le cas piézo-résistif ou mesure de fréquence de résonance dans le cas d'une jauge de type résonateur).

Un dispositif selon l'invention peut en outre comporter des moyens formant contact électrique, sur une première face (dite face avant) ou sur une deuxième face (dite face arrière) du dispositif.

Un dispositif selon l'invention est un capteur de pression relative : une mesure de variations de pression a lieu, entre la pression « instantanée » du milieu extérieur mesuré et une pression « moyenne » de ce même milieu extérieur (ou une pression de référence autre); cette pression moyenne est par exemple obtenue par le « back volume » (ou cavité secondaire), en contact avec le milieu extérieur.

L'invention concerne également un dispositif de récupération d'énergie acoustique, comportant un capteur selon l'invention, et des moyens de stockage d'énergie électrique résultant desdites variations de pression ou produite à la suite de ces variations de pression.

L'invention concerne également un procédé selon la revendication 11 pour réaliser un capteur de pression de type MEMS et/ou NEMS comportant, dans cet ordre ou dans un autre ordre:
- la réalisation, dans au moins un premier substrat, d'au moins une première cavité déformable pour recevoir des variations de pression d'une atmosphère ambiante, cette cavité déformable étant délimitée par au moins une paroi mobile ou déformable,
- la réalisation de moyens de détection pour détecter un déplacement ou une déformation, dans le plan du substrat, dit plan du capteur, de ladite paroi mobile ou déformable, sous l'effet d'une variation de pression,
- la réalisation de moyens pour transmettre à cette cavité des variations de pression d'une atmosphère ambiante.

Un tel procédé peut comporter en outre la réalisation d'au moins une cavité secondaire, ou cavité tampon, en partie en communication avec la première cavité.

Au moins une cavité secondaire peut être réalisée dans le plan d'un deuxième substrat, différent du premier substrat, ou dans le plan du premier substrat.

Dans un procédé selon l'invention, le premier substrat et le deuxième substrat peuvent être assemblés par l'intermédiaire d'une couche diélectrique pour former un substrat de type SOI.

Un procédé selon l'invention peut en outre comporter un assemblage du premier substrat avec un troisième substrat, pour former des moyens pour transmettre lesdites variations de pression à la première cavité.

Les moyens de détection peuvent être réalisés au moins en partie dans le premier substrat.

### BRÈVE DESCRIPTION DES DESSINS

- Les figures 1A et 1B représentent des exemples de dispositif selon l'art antérieur,
- les figures 2A-2C représentent, en vue de côté, en coupe, et en vue de dessus, un mode de réalisation d'un dispositif selon l'invention, et une variante,
- les figures 3A et 3B représentent, en vue de côté, en coupe, et en vue de dessus, un mode de réalisation d'une variante d'un dispositif selon l'invention,
- les figures 4 - 6, 8, 9 représentent chacune, en vue de dessus, un mode de réalisation d'une variante d'un dispositif selon l'invention,
- les figures 7A et 7B représentent, en vue de côté, en coupe, et en vue de dessus, un mode de réalisation d'une autre variante d'un dispositif selon l'invention,
- les figures 10A - 10G représentent un exemple d'un procédé de réalisation d'un dispositif selon l'invention,
- les figures 11A - 11F représentent un exemple d'un autre procédé de réalisation d'un dispositif selon l'invention,
- les figures 12A - 12C représentent des étapes d'une variante d'un autre procédé de réalisation d'un dispositif selon l'invention,
- les figures 13A - 15B représentent, en vue de dessus, d'autres modes de réalisation d'un dispositif selon l'invention,
- les figures 16A et 16B représentent une variante d'une cavité secondaire (ou « back volume ») d'un dispositif selon l'invention.

### EXPOSÉ DÉTAILLÉ DE MODES DE RÉALISATION DE L'INVENTION

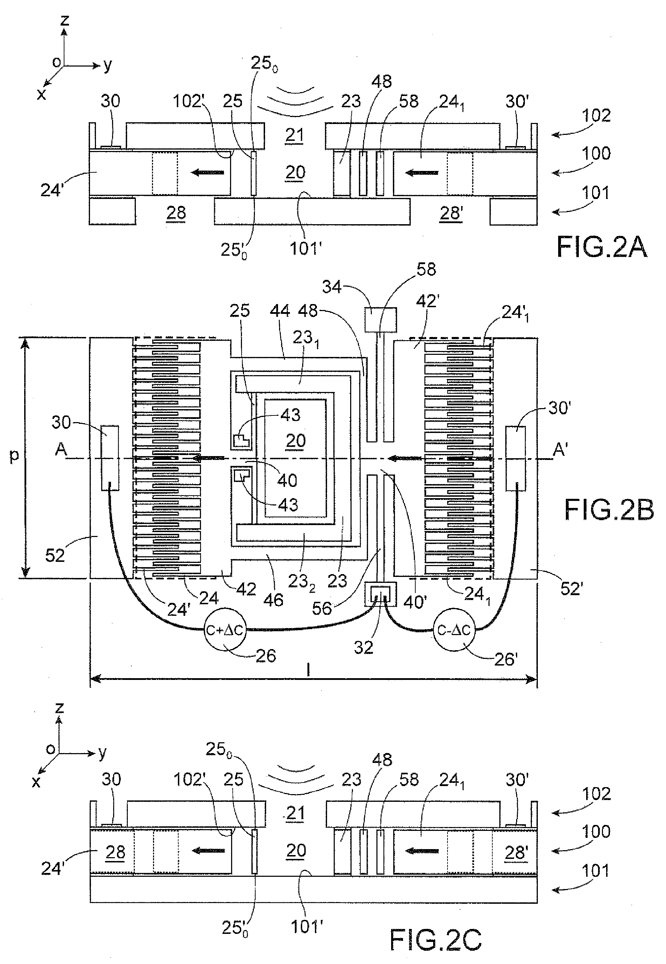

Un premier exemple de structure selon l'invention est illustré en figure 2A, qui est une vue en coupe le long d'un plan dont on voit la trace AA' en figure 2B (vue de dessus).

Dans la suite, lorsqu'on parle de « substrat » 100, 101, 102, on peut également comprendre une « couche ». Par conséquent, pour ces trois éléments, on utilise indifféremment l'un ou l'autre de ces termes.

Une structure selon l'invention peut être réalisée dans 2 ou 3 substrats 100, 101, 102 (le cas de la figure 2A est avec 3 substrats) superposés et assemblés entre eux, le substrat 100 étant disposé entre le substrat 101 et le substrat 102. Chacun des substrats 100, 102 a une épaisseur par exemple comprise entre quelques µm et quelques dizaines de µm, par exemple entre 1 µm ou 5 µm et 10 µm ou 50 µm. Le substrat 101 a une épaisseur par exemple comprise entre quelques dizaines de µm et quelques centaines de µm, par exemple comprise entre 100 µm ou 500 µm et 1000 µm, par exemple sensiblement voisine de 750 µm. Ces dimensions peuvent valoir pour tous les dispositifs décrits dans la suite.

Chacun de ces substrats s'étend dans un plan xy, l'axe z étant perpendiculaire à chacun d'entre eux. L'épaisseur de chaque substrat, mesurée suivant cet axe z, peut, dans certains cas, être très petite devant les extensions latérales du dispositif, c'est-à-dire devant les dimensions p et I de dispositif mesurées dans le plan xy ; p (mesurée selon l'axe x) est par exemple comprise entre 100 µm et 1 mm et I (mesurée selon l'axe y) est par exemple de l'ordre de quelques centaines de micromètres, par exemple comprise entre 100 µm et 500 µm ou 1 mm. Les substrats peuvent être chacun en un matériau semi-conducteur (par exemple en Silicium ou en SiGe). Ils sont liés entre eux par des zones de collage, par exemple via une ou plusieurs couches favorisant l'adhérence, comme une couche d'oxyde de silicium, à l'interface de deux substrats, sauf dans les zones présentant un caractère mobile comme expliqué ci-dessous. Dans la suite, on appellera plan du dispositif le plan xy. On retrouve cette structure dans les autres exemples de réalisation présentés ci-dessous. Ces aspects de l'invention peuvent valoir pour tous les dispositifs décrits dans la suite.

On appelle, dans la suite, partie ou côté inférieur du dispositif la partie tournée vers le substrat 101 et partie ou côté supérieur du dispositif la partie tournée du côté opposé, vers le substrat 102.

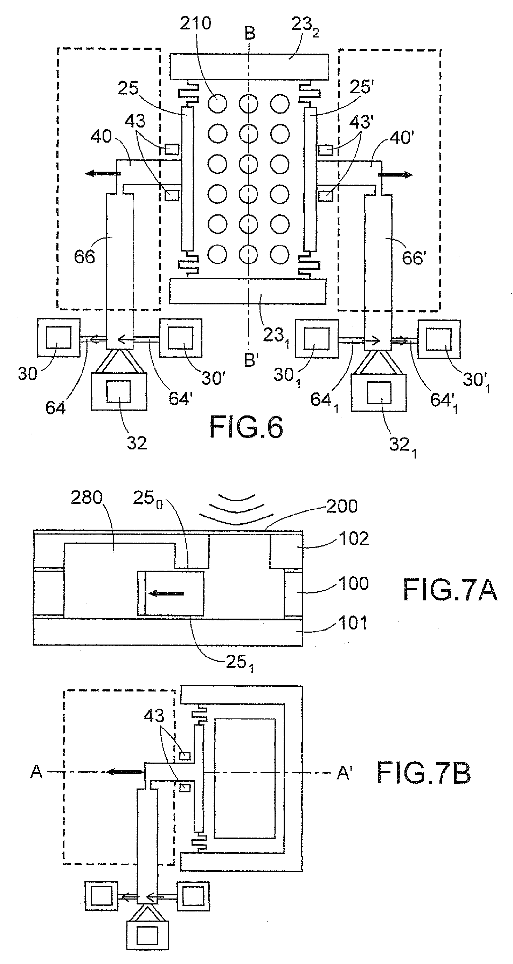

Le dispositif comporte d'abord une cavité 20, réalisée dans le substrat 100 ; cette cavité est ouverte vers le haut, c'est-à-dire qu'elle comporte une ouverture dans la partie supérieure du substrat 100. Une ouverture 21, qui communique avec celle du substrat 100, est également réalisée dans le substrat 102. En variante (dont on verra des exemples ci-dessous) cette ouverture comporte une pluralité d'orifices formant une grille, par exemple pour limiter l'introduction d'éléments étrangers, tels que des poussières, dans la cavité 20. Elle peut donc alors assurer en outre la fonction de filtre. En variante encore, la cavité est fermée par une membrane souple, comme la membrane 200 représentée en figure 7A.

Dans le plan du substrat 100, la cavité 20 est délimitée par des parois latérales 23, 23₁, 23₂, 25 dont certaines (les parois 23, 23₁, 23₂,) sont fixes et au moins une autre (ici la paroi 25) est mobile dans le plan xy du dispositif. Dans l'exemple qui est représenté sur les figures 2A et 2B, la cavité 20 a une forme rectangulaire dans le plan du dispositif, mais une autre forme peut être réalisée.

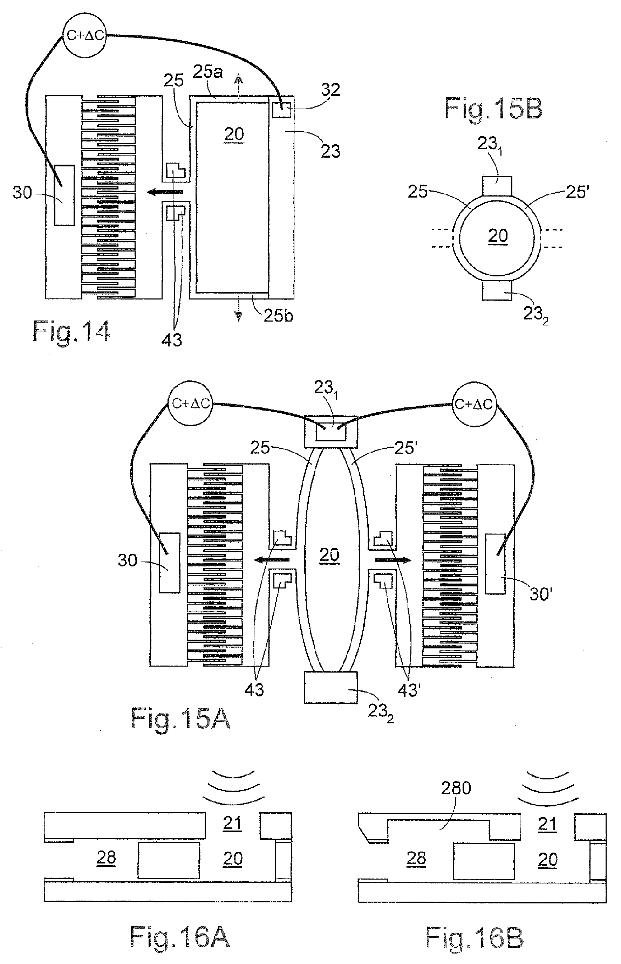

D'autres structures de cavité 20, comportant essentiellement des parois mobiles reliées à une des parties fixées du dispositif, seront détaillées ci-dessous, en liaison avec les figures 14 et 15. En particulier, la structure de la figure 15 est une variante de celle des figures 2A et 2B, en ce sens qu'elle comporte les mêmes moyens de détection, de type peignes capacitifs montés pour réaliser une mesure différentielle.

L'atmosphère, dont la pression est à mesurer, peut pénétrer dans cette cavité 20 par l'ouverture 21. Sous l'effet d'une variation de pression (par rapport à la pression moyenne), la paroi 25 mobile va être déplacée ou déformée dans le plan xy. Les variations de pression ou une onde de pression de l'atmosphère ambiante, arrivent perpendiculairement à la structure, ou au plan du capteur.

Dans l'exemple représenté, les extrémités de la paroi mobile 25 sont fixées à deux parois fixes 23₁, 23₂, et c'est donc ici une déformation de la paroi mobile qui aura lieu. La paroi est donc ici de type »encastré - encastré », c'est-à-dire que ses deux extrémités latérales sont encastrées dans une partie fixe du dispositif. Cette paroi peut avoir approximativement les caractéristiques géométriques suivantes :
-hauteur (mesurée selon l'axe z): sensiblement égale à l'épaisseur du substrat 100, donc comprise entre quelque dizaines de µm et quelques centaines de µm ; mais, dans certains modes de réalisation, elle peut être comprise entre quelques µm et quelques dizaines de µm (par exemple entre 5 µm et 50 µm),
- largeur (mesurée suivant l'axe y): par exemple comprise entre 0,5 µm et 10 µm ; cette largeur est suffisamment faible pour que la paroi 25 présente la sensibilité voulue aux variations de pression se produisant dans la cavité 20,
- longueur (mesurée suivant l'axe x) : par exemple comprise entre 100 µm et 1 mm.

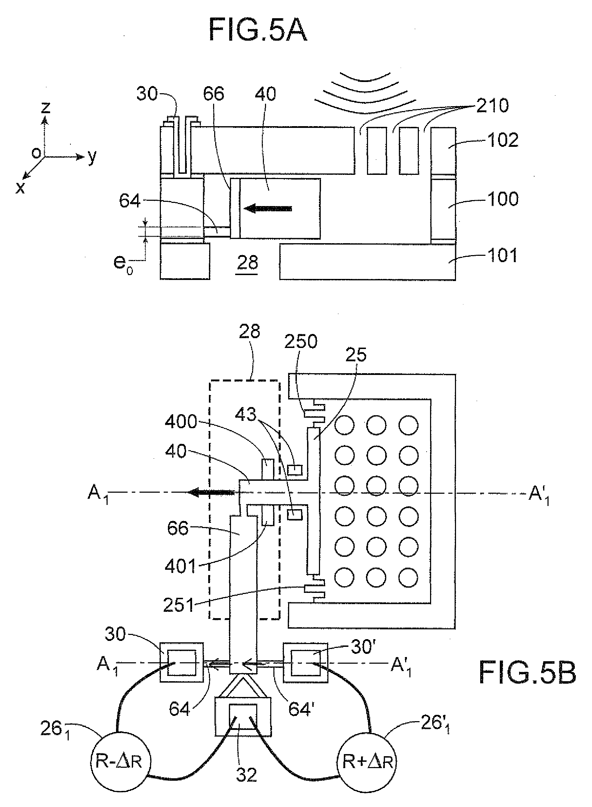

La paroi mobile, en variante, peut être du type présenté plus loin, en liaison avec les figures 5A et 5B: elle comporte alors une partie principale, rigide, qui se déplace sous l'action de la pression, et au moins une ou deux partie(s) latérale(s) 250, 251 formant « ressort», reliée à la partie fixe et déformable.

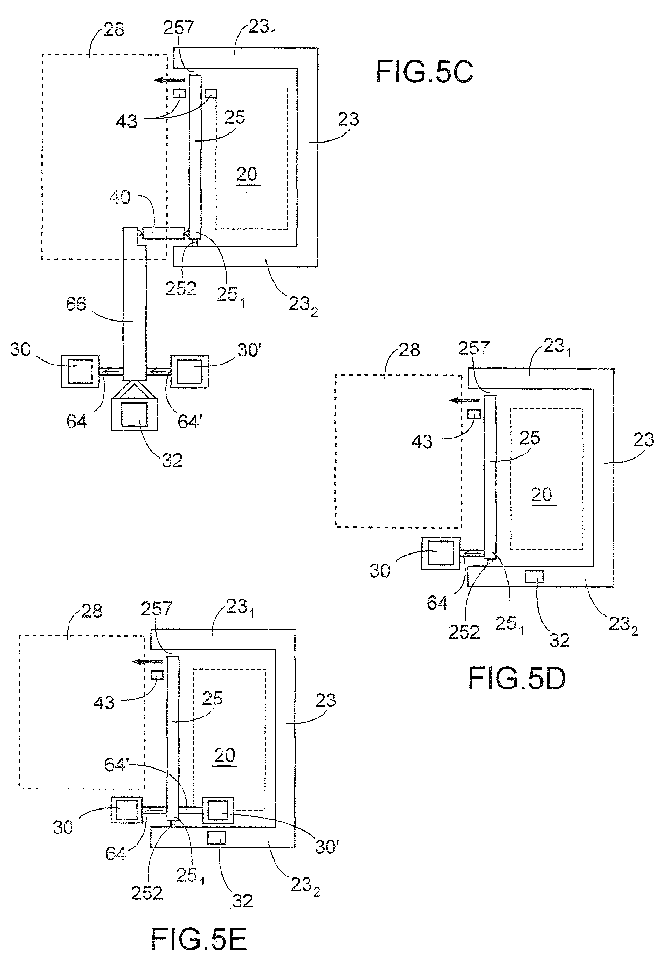

Encore un autre exemple de paroi pouvant être mise en oeuvre dans un dispositif selon l'invention est la structure de paroi de type « encastré - libre », qui sera détaillée plus loin en liaison avec les figures 5C et 5D.

Dans le présent mode de réalisation, comme dans les exemples de réalisation suivants, on peut utiliser l'un ou l'autre des différents types de paroi ou membrane déformable qui vient d'être présentés ou qui seront présentées dans la suite de ce texte.

En variante, plusieurs cavités peuvent être réalisées dans le substrat 100, on en verra des exemples plus loin.

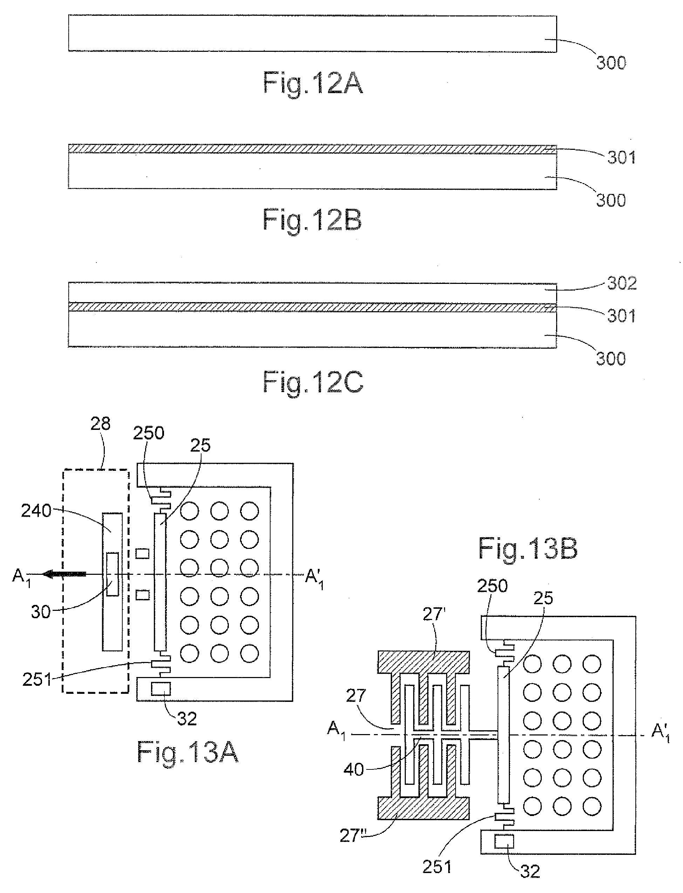

Des moyens 24 de détection sont associés à la paroi mobile, ces moyens ayant ici la forme de peignes capacitifs. Ces peignes capacitifs se sont disposés selon une configuration particulière, qui sera expliquée ci-dessous, avec un déplacement de la partie mobile des peignes selon l'axe y et selon la direction d'extension des dents du peigne. Mais d'autres configurations sont possibles, telle que celle de la figure 13B, avec une direction d'extension des dents du peigne selon l'axe x (et un mouvement de la partie du peigne selon l'axe y). Une détection capacitive peut également mettre en oeuvre une électrode fixe 240 en regard de la membrane déformable 25, comme illustré en figure 13A. En variante, ces moyens de détection peuvent comporter une ou plusieurs jauge(s) de contrainte, par exemple une ou plusieurs jauges piézo-résistives suspendues. Là encore, on en verra des exemples ci-dessous.

Quelle que soit la nature des moyens de détection, une mesure ou détection différentielle peut être mise en oeuvre, comme expliqué plus loin. C'est notamment le cas lorsque les parois qui délimitent la cavité 20 comportent 2 parois mobiles suivant des directions opposées. Les moyens 24 mettent en oeuvre une variation d'un paramètre physique dont les variations vont permettre de détecter une variation du volume de la cavité 20. Ils peuvent donc être associés à des moyens 26 qui permettent de mesurer une variation de ce paramètre physique des moyens 24 de détection, ici une variation de capacité lorsque varie la position relative des peignes. Lorsque l'une des parois mobiles est déplacée ou déformée, les moyens 24, 26 de détection détectent le déplacement ou la déformation correspondante ou la variation correspondante du volume 20.

Dans cet exemple, comme dans les exemples ci-dessous, la cavité 20 et les moyens 24 sont réalisés dans le substrat 100 intermédiaire.

La cavité 20 reçoit les variations de pression à mesurer. L'autre côté de la membrane ou de la paroi 25 est en contact avec la pression ambiante «moyenne », par exemple la pression atmosphérique. À cette fin, le dispositif peut comporter au moins une cavité secondaire ou inférieure 28, 28', réalisée dans le substrat inférieur 101. Cette cavité est ouverte sous le dispositif. En variante encore, expliquée plus précisément plus loin, on peut réaliser une cavité secondaire fermée au-dessus ou au-dessous du dispositif, mais alors de préférence suffisamment volumineuse (son volume peut être alors d'au moins plusieurs fois le volume de la cavité 20, par exemple au moins 5 fois le volume de cette dernière, par exemple 10 fois le volume de cette cavité 20) pour permettre à la structure mobile de se déplacer sous l'effet d'une variation de pression extérieure sans amortissement excessif.

Encore selon une autre variante, une ou plusieurs cavités secondaires 28, 28' peuvent être ouverte(s) (ou éventuellement fermée(s)) sur le côté, par exemple au moins une cavité de ce type est réalisée dans le substrat intermédiaire 100. Des exemples des cavités latérales sont illustrés en figure 2C, 16A-16B.

Quelle que soit sa forme et sa position dans le dispositif, cette cavité secondaire est aussi désignée par l'expression « back volume ». Elle est située, en figures 2A et 2B, et dans la plupart des autres modes de réalisation illustrés, dans un plan ou substrat 101 ou 102 (cas de la figure 7A) différent de celui de la cavité 20 et des moyens 24. Par contre, dans le cas des figures 2C, 16A-16B, elle est réalisée dans le même substrat que celui de la cavité principale à 20.

Dans le présent exemple, cette cavité secondaire est décalée, dans son propre plan par rapport à la cavité 20. En d'autres termes, il n'y a pas d'intersection entre la projection, dans le plan du substrat 101, de la cavité principale 20, et le contour de la cavité secondaire 28.

Mais il existe aussi une communication entre ces deux cavités, ou, plus généralement, entre les cavités principales et chacune des cavités secondaires, car un espace, qui peut être assez faible, est maintenu entre, d'une part, la partie supérieure 25₀ et/ou la partie inférieure 25'₀ de la paroi 25 et la surface supérieure 101' du substrat 101 et la surface inférieure 102' du substrat 102. On assure ainsi une fuite entre les deux cavités 20 et 28. Ainsi, quelle que soit la pression et la position de la paroi mobile, la cavité 20, qui est en communication avec l'atmosphère extérieure par l'ouverture 21, est également en communication avec l'une quelconque des cavités secondaires 28, 28'. Une ou plusieurs de ces cavités secondaires permet de réduire les effets de compression du gaz lors d'un déplacement de la membrane, ce qui est avantageux puisqu'une telle compression tend à diminuer la sensibilité du dispositif. Cette ou ces cavités peuvent aussi être dénommées cavités d'amortissement ou cavités de référence(car elles contiennent la pression moyenne de référence, la mesure de la variation de pression extérieure à mesurer se faisant par rapport à cette pression moyenne de référence).

La cavité déformable 20, et la ou les cavités 28, 28' secondaires ou d'amortissement sont donc partiellement en communication et partiellement séparées au moins par la paroi ou membrane 25, qui est elle-même susceptible de se déplacer (ou se déformer) dans le plan du substrat sous l'effet d'une variation de pression entre la cavité 20 et la (ou les) cavités 28, 28'.

Le dispositif comporte en outre des zones de contact 30, 30', 32. Ces zones de contact permettent d'appliquer une différence de tension entre parties mobile et fixe du dispositif mais elles peuvent aussi permettre de connecter des moyens 26, 26' de mesure d'une variation du paramètre physique, ici une variation de capacité, lorsque l'un des peignes se déplace. Dans l'exemple représenté, ces contacts sont disposés en face avant du dispositif, c'est-à-dire qu'on peut y avoir accès par, ou ils peuvent être réalisés dans, des ouvertures formées dans le substrat 102. Mais, en variante, il est également possible de réaliser des contacts en face arrière, comme on le verra dans des exemples ci-dessous.

On décrit maintenant de manière un peu plus détaillée la structure des peignes capacitifs 24 utilisés en tant que moyens de détection pour le mode de réalisation qui a été présenté ci-dessus. Comme on le verra plus loin, d'autres moyens de détection capacitive peuvent être prévus.

Un premier peigne est lié à la paroi mobile 25 par l'intermédiaire d'un bras 40 qui s'étend sensiblement suivant l'axe y. Lorsque la paroi 25 est déplacée suivant la direction indiquée sur la figure 2B (en fait elle aussi selon la direction y), du fait d'un accroissement (respectivement d'une diminution) de pression dans la cavité 20, cette paroi pousse (respectivement tire) le bras 40 qui lui-même pousse (respectivement tire) le peigne 24. L'amplitude du mouvement de la paroi 25 peut être limitée par une ou des butées mécaniques 43 fixes disposées sur le trajet de la paroi, par exemple de part et d'autre du bras 40.

Le peigne 24 présente des dents parallèles entre elles, chaque dent s'étendant dans le plan zy. Ces dents sont réalisées dans le substrat 100. Elles sont toutes fixées à un bras 42, disposé de manière sensiblement perpendiculaire au plan zy, donc plutôt selon l'axe x et perpendiculairement au bras 40.

À une partie fixe 52 du dispositif, également réalisée sous forme d'un bras sensiblement parallèle au bras 42, est également fixé ou relié un peigne 24' qui présente lui aussi une rangée de dents parallèles entres elles, chacune elle aussi disposée dans un plan de direction zy. Ces dents de la partie fixe sont également réalisées dans le substrat 100.

Les dents des deux rangées de dents des peignes 24, 24' sont alternées, en ce sens qu'une partie de chaque dent (sauf éventuellement les dents situées à l'extrémité d'une rangée de dents) du peigne 24 est disposée entre deux dents voisines du peigne 24'. Et une partie de chaque dent (sauf éventuellement les dents situées à l'extrémité d'une rangée de dents) de chaque peigne est disposée entre deux dents voisines de l'autre.

Chaque dent peut avoir une épaisseur, mesurée suivant l'axe x, comprise entre 5 et 100 µm. Deux dents voisines d'un même peigne sont séparées par une distance pouvant être comprise entre 0,5 µm et 10 µm.

Les dents des 2 peignes sont conductrices du point de vue électrique.

Lorsque le dispositif est au repos et lorsqu'une différence de tension appropriée est établie entre les deux rangées de dents, un ensemble de capacités en parallèle est réalisé. Un déplacement de la paroi 25 entraîne, par l'intermédiaire du bras 40, un déplacement des dents du peigne mobile 24 par rapport aux dents du peigne fixe 24', ce qui entraîne une variation de l'ensemble de capacités. Cette variation est détectée par les moyens 26 et traduit le déplacement de la paroi 25.

Dans le mode de réalisation de la figure 2B, on voit que le bras 42 constitue en fait l'un des côtés d'un cadre mobile, mais indéformable, comportant trois autres bras ou côtés 44, 46, 48 qui entourent les parois 23, 23₁, 23₂, 25 délimitant la cavité 20. C'est donc l'ensemble de ce cadre qui est entraîné en mouvement lorsque la paroi 25 vient à se déplacer ou déformer du fait d'une variation de pression dans la cavité 20. Le côté ou le bras 48, opposé au bras 42 peut lui aussi être relié, par un bras 40', dirigé suivant l'axe x, à un peigne mobile 24₁, qui est donc lui aussi entraîné en déplacement, suivant la même direction que le bras 40', lors d'un mouvement de la paroi 25. Le peigne 24₁ est lui aussi réalisé dans le substrat 100. Ses dents sont toutes fixées à un bras 42', disposé de manière sensiblement perpendiculaire au plan zy, donc plutôt selon l'axe x et perpendiculairement au bras 40'. Le cadre mobile assure notamment une fonction de transmission du mouvement au deuxième peigne mobile 24₁.

Enfin, à ce peigne 24₁ est associé un peigne fixe 24'₁, dont les dents sont fixées à une partie fixe 52' du dispositif et avec lequel il coopère de la même manière que le peigne mobile 24 coopère avec le peigne fixe 24'. L'arrangement relatif, alterné, des dents de ces deux peignes 24₁, 24'₁ est similaire ou identique à ce qui a déjà été décrit ci-dessus pour les deux peignes 24, 24'. La partie fixe 52' est également réalisée sous forme d'un bras sensiblement parallèle au bras 42'. A cette partie fixe 52' sont fixées ou reliées les dents du peigne 24', disposées sous forme d'une rangée de dents parallèles entres elles, chacune elle aussi disposée dans un plan de direction zy. Le bras 52' et les dents du peigne fixe 24'₁ sont également réalisés dans le substrat 100.

Chaque dent de chaque peigne 24₁, 24_{'}1 peut avoir une largeur, mesurée suivant l'axe x, comprise entre 1 µm et 10 µm. Deux dents voisines d'un même peigne sont séparées par une distance pouvant être comprise entre 0,5 µm et 10µm.

Les dents des 2 peignes 24₁, 24'₁ sont conductrices du point de vue électrique.

Lorsque le dispositif est au repos et lorsqu'une différence de tension appropriée est établie entre les deux rangées de dents des deux peignes 24₁, 24'₁, un ensemble de capacités en parallèle est réalisé. Un déplacement de la paroi 25 entraîne, par l'intermédiaire des bras 40, 42, 44, 46, 48, 40' un déplacement des dents du peigne mobile 24₁ par rapport aux dents du peigne fixe 24'₁, ce qui entraîne une variation de l'ensemble de capacités. Cette variation est détectée par les moyens 26' et traduit le déplacement de la paroi 25.

Ce dispositif peut également comporter des moyens 56,58 de guidage, dans le plan xy dans lequel se déplacent la membrane la paroi mobile ou déformable ainsi que les moyens de détection.

Ces moyens ont ici la forme d'au moins un bras 56,58, par exemple de deux bras, chacun disposé sensiblement suivant la direction x, dans le plan xz, mais d'une largeur (pouvant être comprise entre 1 µm et 10 µm), suivant la direction y, suffisamment faible pour permettre, à chacun de ces bras, d'avoir, suivant cette même direction x, une flexibilité suffisante lors d'un mouvement qui résulte d'un déplacement de la paroi 25.

Le bras 56 peut être disposé, comme illustré en figure 2A, entre le côté 48 du cadre mobile formé autour de la cavité 20, et le bras 42' du deuxième peigne mobile 24₁. Etant mécaniquement relié à la partie fixe du dispositif il permet de guider le déplacement de la partie mobile dans le plan du substrat 100 et de ramener cette partie mobile à sa position de départ après retour d'une pression interne à la cavité 20 à sa valeur initiale, avant variation. Un deuxième bras 58, qui peut être symétrique du bras 56 par rapport à un axe parallèle à l'axe y, et relié lui aussi à une partie fixe 34 du dispositif, permet lui aussi d'assurer cette fonction de guidage de la partie mobile. Le bras 58 peut présenter les mêmes caractéristiques géométriques et d'élasticité que le bras 56.

En outre, des moyens permettent d'appliquer à la partie mobile du dispositif la tension appropriée pour permettre à chacun des peignes électrostatiques de jouer son rôle.

Ces moyens pour appliquer une tension peuvent utiliser, ou être combiné avec, au moins l'un des bras 56, 58. Par exemple, le bras 56 est lui-même relié, mécaniquement et électriquement, à l'un des plots de contact 32 auquel la tension souhaitée peut être appliquée. Des plots 30, 30' sont également prévus dans d'autre parties fixes du dispositif, par exemple dans les parties 52,52'.

Lorsque le dispositif comporte, comme décrit ci-dessus, deux systèmes de peignes de chaque côté du dispositif, le déplacement ou la déformation de la paroi 25 entraîne une variation dans un premier sens des capacités de l'un des deux systèmes de peignes, et une variation dans un deuxième sens, de signe opposé au premier, des capacités de l'autre de ces deux systèmes. On a donc un système de détection capacitive différentielle.

Les moyens formant peigne, les bras 42, 44, 46, 48 formant le cadre autour des parois de la cavité 20, les bras 40, 40', sont formés dans le même substrat 100.

D'autres exemples de dispositif selon l'invention vont être présentés ci-dessous.

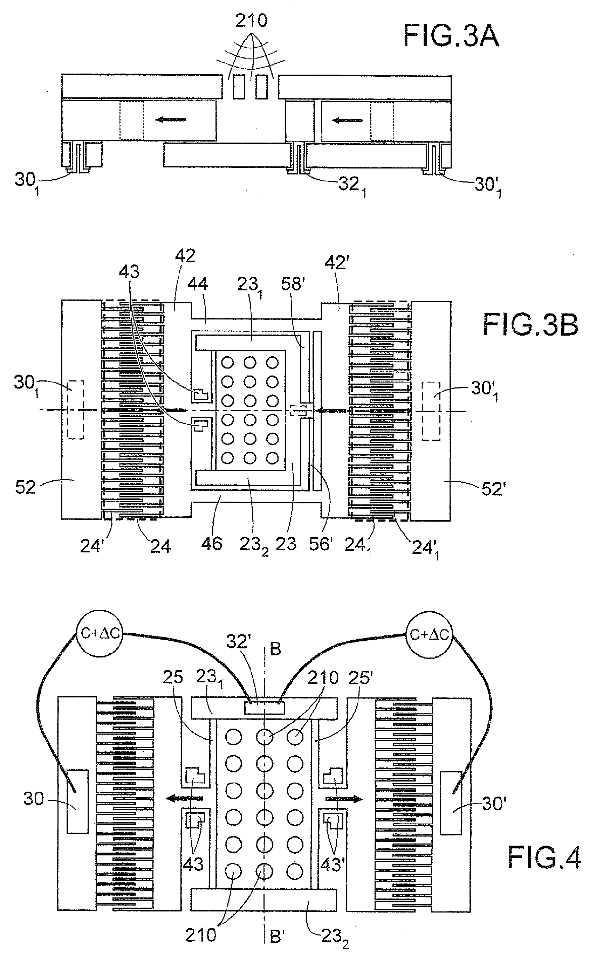

Selon un deuxième exemple, représenté en figures 3A et 3B, un capteur selon l'invention met en oeuvre lui aussi une détection capacitive différentielle, avec des moyens identiques ou similaires à ceux décrits ci-dessus en liaison avec le premier exemple. Mais l'ouverture unique 21 du premier exemple est en fait remplacée par un ensemble de perforations 210 réalisées dans le substrat 102. On réalise ainsi une ouverture supérieure ayant une fonction de filtre, permettant par exemple de filtrer et limiter l'entrée de poussières dans la cavité 20.

Dans ce deuxième exemple, les connexions ou les contacts électriques 30₁, 30'₁, 32₁ sont réalisés sur la face arrière du composant, qui est la face sur laquelle débouchent les cavités 28, 28'. Ces contacts ont les mêmes fonctions que les contacts 30, 30', 32 du premier exemple décrit ci-dessus. Mais ils sont réalisés en surface du substrat 101 inférieur, ou dans ce substrat 101 inférieur.

On voit que, dans cet exemple, le cadre mobile est réalisé de manière plus simple puisque les deux bras 42, 42' forment chacun un côté de ce cadre mobile. A ces bras sont reliés, selon la direction y, deux bras transversaux 44, 46, parallèles entre eux. Des bras 56', 58' de guidage sont cette fois situés à l'intérieur du cadre mobile, ils sont reliés d'une part à la partie mobile, plus particulièrement aux bras 44, 46, et d'autre part à une paroi fixe 23 de la cavité 20.

On peut modifier le premier exemple pour y remplacer les contacts avant par des contacts arrière et la structure de cadre mobile décrite plus haut par celle du deuxième exemple.

Un troisième exemple est représenté en vue de dessus en figure 4. Il comporte deux parois mobiles 25, 25', chacune étant liée à son propre système de peignes de détection capacitive. Ces deux parois sont sensiblement parallèles entre elles lorsque le système est au repos.

Dans cet exemple, les extrémités de chacune des parois mobiles 25, 25' sont fixées à deux parois fixes 23₁, 23₂ parallèles entre elles et c'est donc une déformation simultanée des parois mobiles qui aura lieu. Chacune de celles-ci est d'une largeur, mesurée suivant l'axe y, suffisamment faible et d'une longueur, mesurée suivant l'axe x, suffisante, pour présenter la sensibilité voulue aux variations de pression se produisant dans la cavité 20.

Dans ce mode de réalisation, chaque ensemble de détection est associé est à une membrane ou une paroi déformable différente.

Dans ce système, une variation de pression dans la cavité 20 entraîne un déplacement ou une déformation simultanée des deux parois 25, 25', mais en sens inverse l'une de l'autre. Il en résulte une variation de capacité dans le même sens des deux systèmes de peignes de détection capacitive, qui sont symétriques l'un de l'autre par rapport à un plan médian, de trace BB' sur la figure 4, du dispositif parallèle au plan xz, ce qui permet de s'affranchir des signaux parasites pouvant provenir d'une accélération extérieure imposée au dispositif selon l'invention. On a donc un système différentiel, qui ne permet pas une mesure différentielle, mais qui permet d'éliminer une composante d'accélération ou d'efforts qui résultent pas d'une variation de pression dans la cavité 20. On verra plus loin un exemple de système différentiel, au sens indiqué ci-dessus, qui permet en outre d'effectuer une mesure différentielle.

Disposant de deux parois 25, 25' mobiles ou déformables, de part et d'autre de la cavité 20 par rapport à l'axe BB', cet exemple permet de ne pas mettre en oeuvre un cadre mobile, tel que le cadre constitué par le bras 42 et les bras ou parois 44, 46, 48 de la figure 2B, pour transmettre le mouvement ou le déplacement de la paroi 25 au deuxième ensemble de peignes 24₁, 24'₁.

Cet exemple de réalisation peut comporter, comme le précédent, des bras de guidage 56, 58.

Dans un quatrième exemple, illustré en figures 5A et 5B (avec des variantes en figures 5C et 5D), c'est une détection de type piézo-résistive qui est mise en oeuvre. La figure 5A est une vue en coupe le long d'un plan dont on voit la trace A₁A'₁ en figure 5B (vue de dessus). La structure de la paroi 25 est du type comportant une partie centrale rigide encadrée par deux parties 250,251 formant «ressort », et qui sont déformables. Sous l'action de la pression, la partie rigide se déplace, les parties 250, 251 étant déformées. Ces parties ramènent également la partie rigide en position initiale lorsque la pression revient à sa valeur initiale, après une variation. On a ici un effet ou un mouvement dit de « piston » de la partie mobile. Mais, on pourrait aussi utiliser, dans le présent mode de réalisation, la forme de membrane, ou de paroi, déformable qui à été présentée ci-dessus en liaison avec les figures précédentes.

Les moyens de détection comportent au moins une jauge suspendue. En figure 5B sont représentées deux jauges suspendues 64, 64', montées en mesure différentielle, mais un système avec une seule jauge peut également être réalisé et fonctionner. L'extrémité de chaque jauge est montée à une extrémité d'un bras de levier 66 rigide, pour transmettre aux jauges 64, 64', depuis le bras 40, une contrainte générée qui résulte du déplacement du bras 66 et l'amplifier. Le bras mobile 40 est, là encore, relié à une paroi mobile ou déformable 25 de la cavité. Il est encore dirigé selon l'axe y. Des ergots 400,401 peuvent être disposés de part et d'autre du bras 40, afin d'assurer la fonction de butée, en combinaison avec les plots fixes 43, notamment dans le cas d'une dépression dans la cavité 20.

Le bras de levier 66 est, en position de repos, sensiblement perpendiculaire au bras 40. Ce bras 66 est relié d'une part au bras mobile 40 et d'autre part, par une liaison pivot, à une partie fixe 32 du dispositif (cette partie fixe joue également, dans cet exemple, le rôle de plot de connexion électrique, mais ce n'est pas obligatoire). Un déplacement du bras 40, sous l'effet d'un déplacement ou d'une déformation de la paroi 25, entraîne un déplacement du bras 66 dans le plan du substrat 100 et la naissance d'une contrainte (en compression ou en traction) là où le bras mobile 66 est relié ou articulé à la partie fixe du dispositif. Lorsque ce bras de levier exerce une compression sur l'une des jauges, il exerce, simultanément, une traction sur l'autre jauge. Des moyens 26₁, 26'₁ permettent de mesurer une variation de résistance de chaque jauge, une variation positive de la résistance de l'une des jauges étant accompagnée d'une variation négative de résistance de l'autre jauge. Lorsque le bras 40 revient dans sa position initiale, la ou les jauges 64, 64' ramène le bras 66 dans sa position initiale (C'est cette position initiale qui est représentée sur la figure 5B). L'articulation, formant pivot, du bras 66 permet de guider le mouvement de ce dernier et d'assurer la fonction de bras de levier.

Comme on le voit sur la figure 5A, les deux bras 40 et 66 peuvent, suivant la direction z, être d'épaisseur E sensiblement égale à celle du substrat 100. Cela permet d'assurer une certaine rigidité des bras 40 et 66 suivant l'axe vertical z, et de maintenir cet ensemble dans le plan du substrat 100.

Chaque jauge 64, 64' peut être d'épaisseur e₀ sensiblement inférieure à E. On a alors des jauges de type nanofil ou NEMS, décrite par exemple dans US-2007/222011 ou FR-09 57462. En variante, chaque jauge peut être de type MEMS, et d'épaisseur sensiblement égale à, ou comparable à, celle des autres éléments 40, 66 de la structure mécanique et celle du substrat 100.

Plus précisément, chaque jauge de contrainte suspendue peut avoir une épaisseur e₀ comprise entre, d'une part, 10 nm ou quelques dizaines de nm (par exemple 40 nm pour une jauge de contrainte du type nanofil ou 200 nm pour une jauge de contrainte suspendue en silicium cristallin ou polycristallin), et, d'autre part, quelques micromètres, par exemple 1 µm ou 5 µm ou 10 µm.

Une jauge dite de type « suspendue » est maintenue entre deux parties dites parties d'extrémités. Sur la figure 5B on voit que la jauge 64 (respectivement 64') est maintenue entre une extrémité reliée ou fixée au contact fixe 30 (respectivement 30'), et une deuxième extrémité reliée ou fixée au bras 66 de sorte qu'une contrainte qui s'exerce sur ce dernier se traduit également par une contrainte sur chaque jauge. Les deux zones d'extrémité peuvent être fixées ou reliées au bras 66 et aux plots fixes 30, 30' par exemple par une liaison de type encastrement. La partie de la jauge, dite partie centrale, disposée entre ces deux parties d'extrémités est de longueur non nulle et n'est en contact avec aucun autre matériau (même si elle peut être enrobée elle-même d'une couche de passivation, en dioxyde de silicium ou en nitrure de silicium par exemple). En général une telle jauge est de forme allongée suivant une direction (ici: une direction parallèle à l'axe y), et de longueur, dite longueur de la jauge, sensiblement plus grande (par exemple d'un facteur 5 à 50) dans cette direction que suivant chaque dimension mesurée dans une section perpendiculaire à ladite direction. Elle est maintenue en deux parties d'extrémités (ou zone d'encastrement) qui sont chacune de longueur faible ou très faible devant la longueur de la jauge ou de sa partie centrale.

Chaque jauge de contrainte s'étend donc dans un plan qui est parallèle au plan du capteur.

Chaque jauge est avantageusement en un matériau piézo-résistif, par exemple en silicium monocristallin ou poly-cristallin, ou elle est composée de nanotubes de carbones, ou de nano-fils de silicium, ou en métal ... etc.

Tout ce qui a été dit ci-dessus sur ce type de jauge reste vrai dans les exemples de réalisation des figures 6, 7A-7B, 9 ou encore dans une variante des figures 14 ou 15, dans laquelle une détection par jauges de contrainte serait réalisée.

Lors d'une variation de position ou d'une déformation de la paroi 25, la résistance de chaque jauge varie, et cette variation de résistance est détectée par les moyens 26₁, 26'₁.

Dans l'exemple décrit en liaison avec les figures 5A et 5B, la paroi mobile 25 est encastrée à ses deux extrémités.

Dans une variante, illustrée en figures 5C et 5D, la paroi 25 comporte une partie rigide, ou partie principale, et une partie souple 252, formant charnière de la partie rigide et reliant cette dernière à une paroi fixe 23₂a. Cette charnière peut avoir une forme quelconque. La partie rigide est libre à son autre extrémité, voisine d'une autre paroi fixe 23₁. Mais, comme on le voit sur la figure, il reste là aussi une communication 257 entre la cavité 20 et une éventuelle cavité secondaire 28. Les moyens de détection sont identiques à ceux qui ont été décrits ci-dessus : on retrouve le bras 40, le bras 66, les jauges 64, 64' et les plots 30, 30', 32. Une extrémité du bras 40 est cette fois positionnée du côté de la paroi 25 qui est proche de la paroi fixe 23₂. L'autre extrémité de la paroi 25 est libre, c'est-à-dire que, lors d'un accroissement de pression dans la cavité 20, la paroi 25 va subir un mouvement de rotation autour de la charnière 252. Il va donc appuyer sur le bras 40, qui entraîne à son tour le bras 66 en mouvement, les contraintes se manifestant à l'extrémité fixe de ce dernier se traduisant par un signal des jauges 64, 64'. Le mouvement de la paroi 25 est limité par la ou les butée(s) 43 : comme représenté sur la figure 5C, on peut positionner une butée de chaque côté de la paroi 25.

Le dispositif illustré en figure 5D fonctionne sur le même principe, mais cette fois une jauge de contrainte 64 est disposée sensiblement perpendiculairement à la paroi 25 lorsque cette dernière est en position de repos, et directement en contact avec une portion de la paroi 25 voisine de la charnière 252. Une contrainte s'exerce donc directement sur la jauge 64 lorsqu'il y a une surpression ou une dépression dans la cavité 20. L'autre extrémité de la jauge est reliée à un plot fixe 30. Un autre plot 32 de connexion peut être disposé sur la partie fixe 23.

Le dispositif illustré en figure 5E fonctionne sur le même principe, mais cette fois ce sont deux jauges de contrainte 64, 64' qui sont disposées sensiblement perpendiculairement à la paroi 25 lorsque cette dernière est en position de repos, et directement en contact avec une portion de la paroi 25 voisine de la charnière 252. Ces deux jauges sont disposées de manière à fournir une mesure différentielle. Une contrainte s'exerce donc directement sur chacune des jauges 64, 64' lorsqu'il y a une surpression ou une dépression dans la cavité 20. L'autre extrémité de chaque jauge est reliée à un plot fixe 30, 30'. Un autre plot 32 de connexion peut être disposé sur la partie fixe 23.

Un cinquième exemple de réalisation de l'invention est illustré en figure 6, en vue de dessus. On a là, de nouveau, un système différentiel, au sens déjà expliqué ci-dessus.

Il comporte deux parois mobiles ou déformables 25, 25', chacune étant liée à son propre système de bras de levier 66, 66' et de jauges piézo-résistives 64, 64' et 64₁, 64'₁ comme en figures 5A et 5B. Un ensemble de plots de connexion peut être prévu pour chaque système de bras et de jauges : ainsi des plots fixes de connexion 30₁, 30'₁, 32₁ sont prévus pour les jauges 64₁, 64'₁ et des plots fixes de connexion 30, 30', 32 sont prévus pour les jauges 64, 64'. Le bras 66, 66' de chaque système est mécaniquement relié à l'un de ces plots fixes de sorte qu'un mouvement de chacun de ces bras se traduit en une contrainte à l'endroit de cette liaison.

Au repos, les deux bras 66, 66' sont sensiblement parallèles entre eux.

Dans ce système, une variation de pression dans la cavité 20 entraîne un déplacement ou une déformation des deux parois 25, 25', mais en sens inverse l'une de l'autre. Il en résulte un mouvement du bras 40 opposé à celui du bras 40' et un mouvement du bras 66 symétrique de celui du bras 66' par rapport au plan BB'. Il en résulte aussi une variation de résistance :
- dans chacune des jauges 64, 64', qui sont reliées au bras de levier 66, lui-même relié au bras 40,
- et dans chacune des jauges 64₁, 64'₁ qui sont reliées au bras de levier 66', lui-même relié au bras 40'.

Là encore, les deux systèmes de mesure de déplacement ou de déformation des parois 25, 25' sont symétriques l'un de l'autre par rapport à un plan médian, de trace BB' sur la figure 6, du dispositif, parallèle au plan xz, ce qui permet de s'affranchir des signaux parasites pouvant provenir d'une accélération extérieure imposée au dispositif selon l'invention.

Dans cet exemple de réalisation, les parois sont de type « piston » comme expliqué ci-dessus, par exemple en liaison avec la figure 5B, mais on peut aussi utiliser des parois ou membranes déformables du type décrit ci-dessus en liaison avec les figures 2A et 2B.

Chacun des exemples des figures 4, 5A-5B, 6 est représenté avec une ouverture supérieure sous forme d'un ensemble de perforations 210, comme dans le deuxième exemple. Mais une ouverture large, comme celle du premier exemple, peut être mise en oeuvre dans ce troisième exemple. On peut aussi, en variante, utiliser une membrane telle que la membrane 200 de la figure 7A ou 7B.

Chacun de ces exemples est en outre représenté avec des contacts en face avant, mais des contacts en face arrière peuvent être réalisés comme dans le deuxième exemple.

Dans chacun des exemples ci-dessus, on peut avoir au moins une cavité secondaire, par exemple inférieure, comme sur les figures 2A - 2B, mais aussi latérale, comme sur les exemples des figures 2C et 16A - 16B, ou supérieure comme dans l'exemple des figures 7A-7B.

Dans un sixième exemple, illustré en figures 7A et 7B, c'est encore une détection de type piézo-résistive qui est mise en oeuvre, comme en figures 5A et 5B. La figure 7A est une vue en coupe le long d'un plan dont on voit la trace AA' en figure 7B (vue de dessus). On pourra se reporter à la description faite ci-dessus, en liaison avec les figures 5A et 5B, pour ce qui concerne les moyens de détection.

Dans cet exemple de réalisation, une cavité 28 n'est pas réalisée dans le substrat inférieur 101. Par contre, une cavité 280 est réalisée en face avant, dans le substrat supérieur 102. Cette cavité a la même fonction que la cavité inférieure 28 des exemples de réalisation précédents. On peut la réaliser avec un volume adapté à cet effet. Elle est fermée par une paroi, afin que la paroi mobile 25 voit, sur un côté, les variations de pression à mesurer (dans la cavité 20) et, sur un autre côté, une pression moyenne qui est peu ou pas affectée par les variations de pression à mesurer.

En outre, la première cavité 20 est ici fermée ou partiellement fermée par une membrane souple 200. Cette membrane permet de transmettre les variations de pression à mesurer et d'éviter l'entrée de poussières ou d'humidité dans la cavité 20. Elle peut être adaptée aux modes de réalisation précédents, par exemple celui des figures 2A- 2B.

Comme dans les modes de réalisation précédents, il y a une communication entre les différentes cavités (d'une part la cavité principale et d'autre part la ou les cavités secondaires) du fait de l'espace entre la partie supérieure (respectivement inférieure) de la paroi 25 et la surface inférieure (respectivement supérieure) du substrat supérieur (respectivement inférieure).

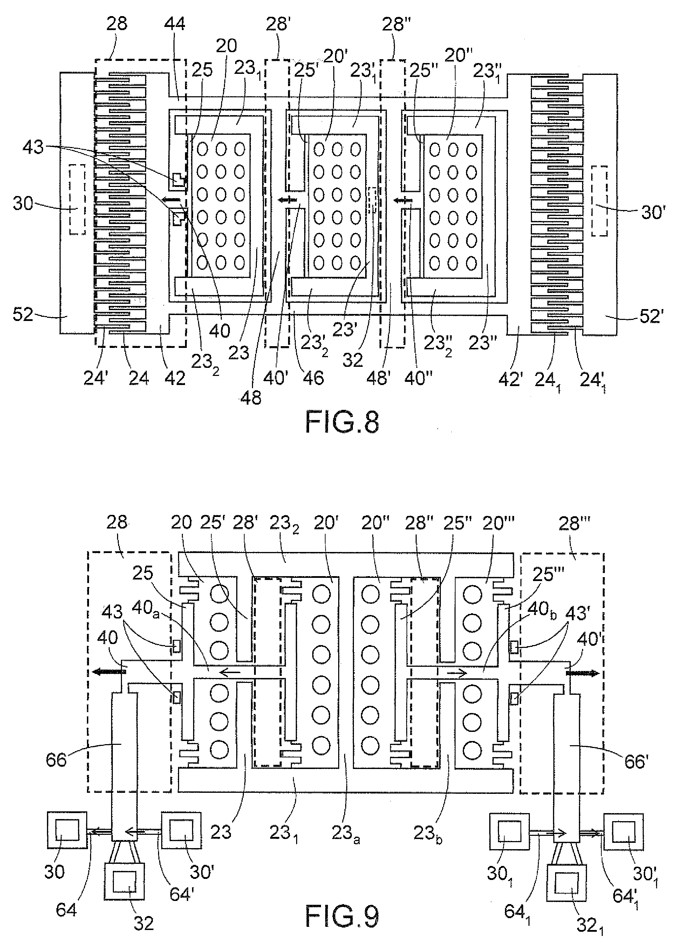

Selon encore un exemple de variante (en figure 8 en vue de dessus) un dispositif selon l'invention utilise un mode de détection capacitif différentiel (comme sur les figures 2A et 2B), mais également une pluralité de cavités 20, 20', 20" disposées en parallèle : il suffit que la pression dans l'une de ces cavités subisse une variation pour que le système de détection capacitive soit entraîné et qu'un mouvement ou une déformation de l'une des parois mobiles ou déformables soit ainsi mesuré. Mais, surtout, ce dispositif permet de cumuler les effets et donc de rendre le composant plus sensible. Dans cet exemple on décrit un dispositif avec trois cavités, mais un dispositif avec deux cavités, ou encore avec plus de trois cavités, peut également être réalisé.

Dans le plan du substrat 100, chaque cavité 20, 20', 20" est délimitée par des parois latérales 23, 23₁, 23₂, 25, 23', 23'₁, 23'₂, 25', 23"₁, 23"₂, 23", 25" dont certaines (les parois 23, 23₁, 23₂, 23', 23'₁, 23'₂, 23", 23"₁, 23"₂) sont fixes et au moins une autre (ici les parois 25, 25', 25") est mobile dans le plan xy du dispositif. Dans l'exemple représenté, chaque cavité 20, 20', 20" a une forme rectangulaire dans le plan du dispositif, mais une autre forme peut être réalisée.

Une onde de pression peut pénétrer dans chaque cavité 20, 20', 20" par l'ouverture supérieure, qui a ici la forme d'un ensemble de perforations 210 réalisées dans le substrat 102. Mais une ouverture unique pour chaque cavité peut aussi être réalisée.

Des moyens 24, 24', 24₁, 24'₁ de détection sont fixés ou, plus généralement, associés aux parois mobiles, ces moyens ayant ici la forme de peignes capacitifs, comme déjà décrit ci-dessus avec les figures 2A et 2B. En variante, ces moyens peuvent comporter une ou plusieurs jauge(s) de contrainte, par exemple une ou plusieurs jauges piézo-résistives suspendues, comme décrit ci-dessous en liaison avec la figure 9. Là encore, ce mode de détection a été déjà décrit ci-dessus, par exemple en liaison avec les figures 5A, 5B ou 6.

Dans le mode de réalisation de la figure 8, on voit que le bras 42 constitue en fait l'un des côtés d'un cadre comportant trois autres bras ou côtés 44, 46, 42' qui entourent l'ensemble des cavités 20, 20', 20". C'est donc l'ensemble de ce cadre qui est entraîné en mouvement lorsque l'une des parois 25, 25', 25" vient à se déplacer du fait d'une variation de pression dans au moins l'une des cavités. Le côté ou le bras 42', opposé au bras 42, peut lui aussi être relié à un peigne mobile 24₁, qui est donc lui aussi entraîné en déplacement, suivant la même direction que le bras 42', lors d'un mouvement de l'une des parois 25, 25', 25".

Deux traverses 48, 48' sont disposées parallèlement aux bras 42, 42' et délimitent des portions de cadre mobile, dans chacune desquelles se trouve une des cavités 20, 20', 20". A chacune de ces traverses est reliée l'extrémité d'un bras 40', 40" dont l'autre extrémité est reliée à une des parois 25', 25".

Le dispositif comporte au moins une cavité inférieure 28, 28', 28" associée à chaque cavité 20, 20', 20". Chaque cavité inférieure est réalisée dans le substrat inférieur 101 et est ouverte sous le dispositif. Les variantes exposées ci-dessus, avec cavité fermée au-dessus ou au-dessous du dispositif, ou une cavité disposée latéralement, peuvent être appliquées à ce mode de réalisation.

Le dispositif comporte en outre des zones de contact 30, 30', 32. Ces zones de contact permettent de relier des moyens de mesure d'une variation du paramètre physique, ici une variation de capacité, lorsque l'un des peignes se déplace. Dans l'exemple représenté, ces contacts sont disposés en face avant du dispositif, c'est-à-dire qu'on peut y avoir accès par, ou ils peuvent être réalisés dans, des ouvertures formées dans le substrat 102. Mais, en variante, il est également possible de réaliser des contacts en face arrière, comme on l'a déjà vu ci-dessous. L'un des contacts est par exemple réalisé dans la partie fixe 52, l'autre dans la partie fixe 52'. Un autre contact 32 peut être formé dans une portion d'un des cadres fixes, par exemple la paroi 23'.

Là encore, des bras de guidage tels que les bras 56, 58, 56', 58' des figures 2 et 3 peuvent être réalisés, mais le fait d'avoir plusieurs parois mobiles permet aussi de ne pas mettre en oeuvre de tels moyens de guidage.

La structure de cette figure 8 n'est pas une structure différentielle : un choc, ou, plus généralement, une accélération extérieure quelconque, sera détecté comme une variation de pression.

Selon encore un exemple de variante (en figure 9 en vue de dessus) un dispositif selon l'invention utilise un mode de détection par jauges de contraintes (comme sur les figures 5A - 7B), mais avec une pluralité de cavités 20, 20', 20", 20'" disposées en parallèle. En particulier, il suffit qu'une variation de pression ait lieu dans la cavité 20 (respectivement 20") pour qu'une détection différentielle soit réalisée avec cavité 20' (respectivement 20"'), ce qui permet de s'affranchir des éventuelles accélérations extérieures.

Dans le plan du substrat 100, chaque cavité 20, 20', 20", 20"' est délimitée par des parois latérales 23, 25, 23₁, 23₂, 23a, 23b, 25', 25", 25"' dont certaines (les parois 23, 25, 23₁, 23₂, 23a, 23b) sont fixes et d'autres (ici les parois 25, 25', 25", 25"') sont mobiles ou déformables dans le plan xy du dispositif. Dans l'exemple représenté chaque cavité 20, 20', 20" a une forme rectangulaire dans le plan du dispositif, mais une autre forme peut être réalisée.

L'atmosphère, dont la pression est à mesurer, peut pénétrer dans chaque cavité 20, 20', 20", 20"' par l'ouverture supérieure, qui a ici la forme d'un ensemble de perforations 210 réalisées dans le substrat 102. Mais une ouverture unique pour chaque cavité peut aussi être réalisée ou bien encore une membrane peut fermer chaque cavité, comme en figure 7A.

Des moyens 66, 66', 64, 64', 64₁, 64'₁ de détection sont fixés ou, plus généralement, associés aux parois mobiles, ces moyens ayant ici la forme de jauges de contrainte, par exemple une ou plusieurs jauges piézo-résistives suspendues, comme déjà décrit ci-dessus en liaison avec les figures 5A, 5B ou 6.

La constitution de la cavité 20 et de ses moyens 40, 66 de transmission de la déformation ou du déplacement aux jauges est très proche de ce qui a déjà été décrit ci-dessus, par exemple en liaison avec la figure 5B.

Une différence réside dans la présence d'un bras 40a qui relie la paroi mobile ou déformable 25' aux moyens de détection 40, 66, 64, 64'. Ce bras traverse la paroi fixe 23 et est fixé à la paroi 25, transmettant ainsi toute déformation ou tout déplacement de la paroi 25' à la paroi 25, et donc aux moyens de détection 40, 66, 64, 64'.

De même un bras 40b relie la paroi mobile ou déformable 25" aux moyens de détection 40', 66', 64₁, 64'₁. Ce bras traverse la paroi fixe 23b et est fixé à la paroi 25"', transmettant ainsi toute déformation ou tout déplacement de la paroi 25" à la paroi 25"', et donc aux moyens de détection 40', 66', 64₁, 64'₁.

Les moyens de détection choisis ici n'ont pas besoin de mettre en oeuvre un cadre mobile autour des cavités, à la différence de l'exemple de réalisation de la figure 8. La fonction de ce cadre est ici assurée par les bras de liaison 40a, 40b , ce qui permet une mise en parallèle des efforts s'exerçant sur les parois 25, 25' et 25", 25"'.

Une paroi centrale 23a n'est traversée par aucun bras et sépare d'un côté les chambres 20, 20' reliées aux moyens de détection 40, 66, 64, 64' et d'un autre côté les chambres 20", 20"' reliées aux moyens de détection 40', 66', 64₁, 64'₁.

Le dispositif comporte au moins une cavité inférieure 28, 28', 28", 28"' associée à chaque cavité 20, 20', 20", 20"'. Chaque cavité est réalisée dans le substrat inférieur 101 et est ouverte sous le dispositif. Les variantes exposées ci-dessus, avec cavité fermée au-dessus ou au-dessous du dispositif, ou au moins une cavité latérale, peuvent être appliquées à ce mode de réalisation.

Le dispositif comporte en outre des zones de contact 30, 30', 32, 30₁, 30'₁, 32₁. Dans l'exemple représenté, ces contacts sont disposés en face avant du dispositif, c'est-à-dire qu'on peut y avoir accès par, ou ils peuvent être réalisés dans, des ouvertures formées dans le substrat 102. Mais, en variante, il est également possible de réaliser des contacts en face arrière, comme on l'a déjà vu ci-dessus.

Un tel système est différentiel en ce qu'il permet de discriminer entre un signal de pression à mesurer et une accélération extérieure. Autrement dit, cette dernière ne sera pas vue comme une perturbation assimilée à une variation de pression. Il fonctionne aussi en mesure différentielle, c'est-à-dire que tout mouvement d'une paroi mobile dans un sens ce produit simultanément à un mouvement de l'autre paroi mobile dans l'autre sens et qu'une variation du signal issu des moyens de détections associés à l'une des parois est en sens inverse d'une variation du signal issu des moyens de détection associés à l'autre paroi.

Dans tous les modes de réalisation décrits, il est possible de réaliser des butées mécaniques 43, 43' pour limiter le déplacement de la membrane déformable ou mobile sous l'effet d'une surpression. Sur tous les modes de réalisation on peut même mettre des butées de chaque côté de la membrane 25, comme par exemple sur la figure 5C ou utiliser des moyens formant ergot sur les bras 40, comme les moyens 400,401 de la figure 5B. Des butées peuvent être formées elles aussi dans le substrat 100.

De préférence, un microphone mesure des pressions acoustiques de quelques dizaines de Hz à 20kHz. On peut avantageusement, dans les modes de réalisation décrits ci-dessus, préciser qu'il est possible d'associer plusieurs microphones présentant des bandes passantes différentes.

Par exemple on peut associer 3 microphones, un premier répondant principalement dans la gamme 10Hz-500Hz, un deuxième microphone dans la gamme 500Hz-5000Hz et un troisième dans la gamme 5kHz-20kHz. Dans un tel système, chaque microphone peut être distinct de chaque autre microphone, chaque membrane 25 ayant une bande passante différente de celle des autres membranes. La bande passante d'une membrane est définie par la fréquence de résonance de cette membrane ; cette fréquence de résonance est de préférence supérieure à fréquence maximale de l'onde de pression à mesurer. Ceci peut être complété par des moyens de filtrage électronique du signal mesuré.

On a représenté en figures 13A un autre dispositif selon l'invention, à détection capacitive, dans lequel la membrane 25 est reliée à une électrode, qui fait face à une électrode fixe 240. Entre ces dernières et les parois fixées de la cavité, peut être établi une différence de potentiel qui va permettre de détecter une variation de la capacité réalisée par les deux électrodes 25, 240 qui se font face. Une différence de potentiel peut être appliquée entre les plots 30,32.

En figure 13B est représentée encore un autre mode de réalisation, dans lequel la détection, encore de type capacitif, est réalisée par un système de peignes, dont les dents sont, cette fois, dirigées suivant l'axe x, non pas suivant l'axe y comme en figures 2A - 2B. Un bras 40, sensiblement perpendiculaire à la paroi 25, supporte les dents de la partie mobile du peigne 27, deux parties fixes 27', 27" du peigne étant disposées, par rapport à chaque rangée de dents, comme déjà expliqué ci-dessus en liaison avec la figure 2B.

La figure 14 illustre un autre aspect d'une variante d'un dispositif selon l'invention, dans lequel la cavité 20 est délimitée par plusieurs parois mobile 25, 25a, 25b, les parois 25a, 25b étant ici disposés de manière sensiblement parallèles entre elles et sensiblement perpendiculaire à la paroi 25 lorsque le dispositif est au repos. Ces parois mobiles sont complétées par une portion ou une paroi fixe 23 du dispositif à laquelle elles sont reliées. Ces parois mobiles et cette paroi fixe délimitent la cavité 20. Les moyens de détection, ici du type capacitif, et plus particulièrement sous la forme d'un système de peignes tel que l'un des systèmes de peignes décrits ci-dessus en liaison avec la figure 2B, vont permettre de détecter tout déplacement ou toute déformation de la paroi mobile 25. Les deux autres parois déformables 25a, 25b auront des mouvements suivant une direction latérale, perpendiculaire à la direction de déformation de la paroi 25, qu'il ne sera pas nécessaire de détecter.

La figure 15A illustre encore une autre variante d'un dispositif selon l'invention, dans lequel la cavité 20 est délimitée par deux parois déformables 25, 25', les extrémités de ces parois déformables étant reliées à des plots 23₁, 23₂ fixes du dispositif. Autrement dit, la cavité 20 est essentiellement délimitée par les parois déformables, des portions fixes des parois étant réduite à une surface très faibles. Les parois 25, 25' délimitent un volume d'une cavité 20, qui va, lors d'une variation de pression, subir des mouvements similaires à ceux d'un ballon qui se gonfle ou se dégonfle. Les moyens de détection, ici du type capacitif, et plus particulièrement sous la forme d'un système de peignes tel que les systèmes de peignes décrits ci-dessus en liaison avec la figure 2B, vont permettre de détecter tout déplacement ou toute déformation des parois mobiles 25, 25'. Le système est donc ici à mesure différentielle. On pourrait réaliser une cavité principale 20, délimitée par plus de deux parois déformables, avec des plots fixes supplémentaires.

La structure de la figure 15B est une variante de celle de la figure 15A, dans laquelle l'intérieur de la cavité principale 20 est délimité que par des parois déformables 25, 25', qui sont par ailleurs reliées, par leur surface extérieure, à au moins un (ici : deux) plots fixes 23₁, 23₂ du dispositif. Une ou plusieurs parties de la ou des parois déformables 25, 25' peut être reliée(s) à des moyens de détection, par exemple de type capacitif ou de type jauges de contrainte, ce qui est symbolisé sur la figure 15B par des pointillés (ces moyens de détection ont déjà été expliqués en liaison avec les figures précédentes).

Un dispositif selon l'invention comporte une partie fixe, c'est-à-dire dont la position n'évolue pas sous l'action d'une variation de pression dans la cavité 20, et une partie mobile, dont la position évolue ou est modifiée sous l'action d'une variation de pression dans la cavité 20. La partie mobile est reliée à la partie fixe par des moyens permettant de la ramener à sa position initiale par rapport à cette dernière lorsque la pression dans la cavité 20 est ramenée à sa valeur initiale ou bien a des propriétés d'élasticité lui permettant de revenir à sa position initiale.

Un dispositif ou un système selon l'invention peut avoir une structure différentielle, qui lui permet de ne détecter que les variations de pression se produisant dans sa cavité principale 20. Les chocs ou les accélérations extérieures sont neutralisées, et ne sont pas détectées. On a déjà donné des exemples ci-dessus de telles structures différentielles.

Un dispositif ou un système selon l'invention peut permettre, dans certaines configurations, une mesure différentielle, c'est-à-dire que des moyens de détection associés à des parois mobiles ou déformables différentes vont avoir des variations de signal de même amplitude, ou sensiblement de même amplitude, mais des signes différents.

Certaines configurations peuvent avoir une structure différentielle, mais ne pas permettre de mesure différentielle.

Certaines autres configurations ont une structure différentielle, mais permettent également une mesure différentielle, y compris pour le cas d'une détection capacitive.

Dans les différents modes de réalisation exposée, la paroi mobile ou déformable peut être de type « encastrée - encastrée » (ses deux extrémités viennent se fixer chacune dans une partie fixe du dispositif), ou "encastrée - libre » (une de ses extrémités vient se fixer dans une partie fixe du dispositif, et l'autre extrémité est libre), ou comporter une partie rigide qui se déplace selon un mouvement de type « piston » en étant accompagnée dans ce mouvement par des portions latérales déformables, par exemple de type « ressort».

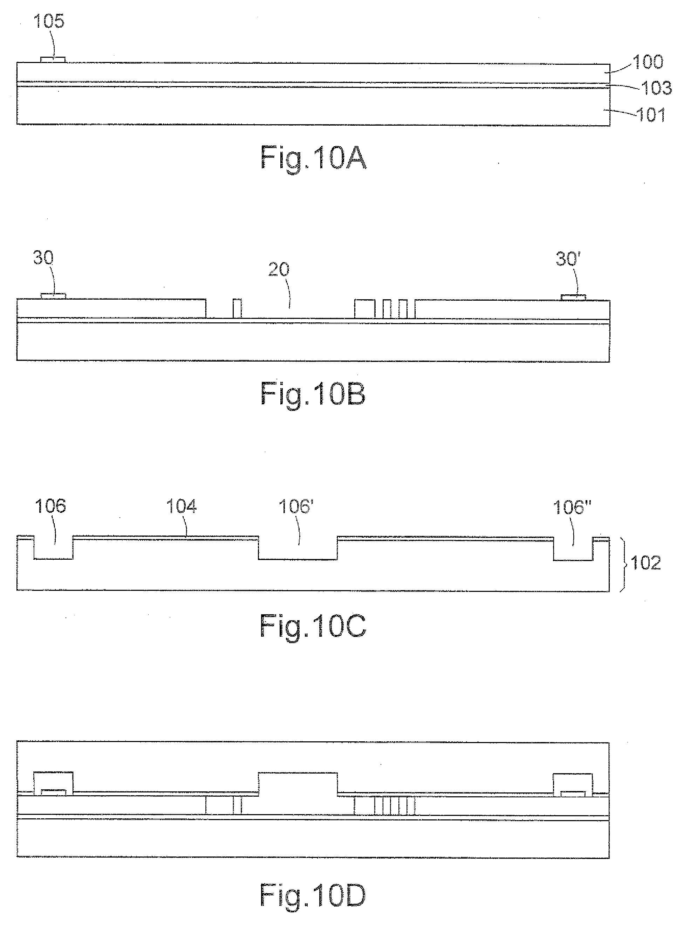

Les figures 10A-10G illustrent un premier exemple d'un procédé pour réaliser un dispositif selon l'invention. Dans cet exemple, les contacts sont en face avant et la cavité 28 est en face arrière.

Il s'agit d'un procédé avec report d'un second substrat.

On part (figure 10A) d'un substrat SOI (avec un oxyde enterré (BOX) 103, par exemple d'épaisseur 0.5 µm). En variante, on part d'un substrat standard 101, sur lequel on réalise un dépôt 103 d'une couche sacrificielle (oxyde) et un dépôt 100 en matériau semi-conducteur, par exemple en silicium ou en SiGe poly-cristallin.

Puis un dépôt 105 de métal (ex : Ti/Au ou AlSi,...) est réalisé, ainsi qu'une lithographie et une gravure des contacts 30, 30'. On peut réaliser les contacts en face arrière par la même technique.

On réalise ensuite (figure 10B) une lithographie et une gravure de la couche de silicium superficielle pour définir la cavité acoustique 20 et la structure mécanique, comportant notamment au moins une paroi mobile ou déformable 25, éventuellement un cadre mobile, éventuellement une ou plusieurs butées, et les éléments de détection (peignes capacitifs ou jauges de contrainte) dont les détails ne sont pas représentés ici : les masques de gravure utilisés sont adaptés pour réaliser les moyens adéquats en fonction du type de détection mis en oeuvre.

Par ailleurs, sur la base d'un substrat Si classique 102, on réalise un dépôt 104 d'oxyde de Silicium (SiO2), par exemple d'épaisseur environ 0.8 µm (figure 10C).

On réalise ensuite une lithographie et une gravure (partielle ou complète) de l'oxyde 104 et du silicium 102 en vue de former des ouvertures 106, 106', 106" pour l'entrée de la pression et l'ouverture des contacts.

Les deux substrats sont ensuite alignés (figure 10D) et scellés (par scellement direct, ou eutectique, ou polymère, ou anodique,...), de sorte que les ouvertures 106, 106', 106" communiquent avec les contacts 30, 30' et la cavité 20.

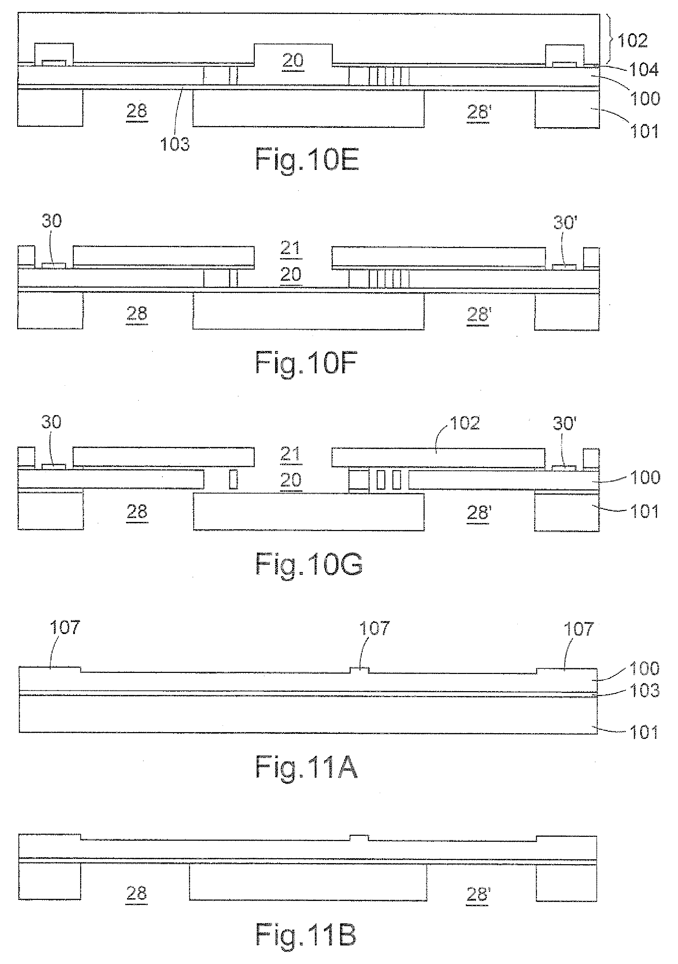

On réalise ensuite (figure 10E) une lithographie et une gravure des ouvertures des cavités 28, 28' en face arrière (« back volume »).

Par amincissement de la face avant (« back-grinding ») on forme une ouverture des cavités 21 et des contacts 30, 30' (figure 10F).

Enfin on libère (figure 10G) la structure mobile par retrait de parties des couches sacrificielles d'oxyde 103, 104 par gravure HF (vapeur par exemple).

Les figures 11A-11F illustrent un second exemple de procédé, avec report d'un substrat isolant (ou laminage d'un film polymère).

On part (figure 11A) d'un substrat SOI, avec un oxyde enterré (BOX) 103, par exemple d'épaisseur 0.5 µm. En variante, on part d'un substrat standard 101, sur lequel on réalise un dépôt 103 d'une couche sacrificielle (oxyde) et un dépôt 100 en matériau semi-conducteur, par exemple en silicium ou en SiGe poly-cristallin.

Puis on réalise une lithographie et une gravure de la couche de silicium superficielle 100 (par exemple sur une épaisseur d'environ 0.8 µm) pour définir des cales 107 d'épaisseur, en face avant.

On réalise ensuite (figure 11B) une lithographie et une gravure des ouvertures des cavités 28, 28' en face arrière (« back volume »).

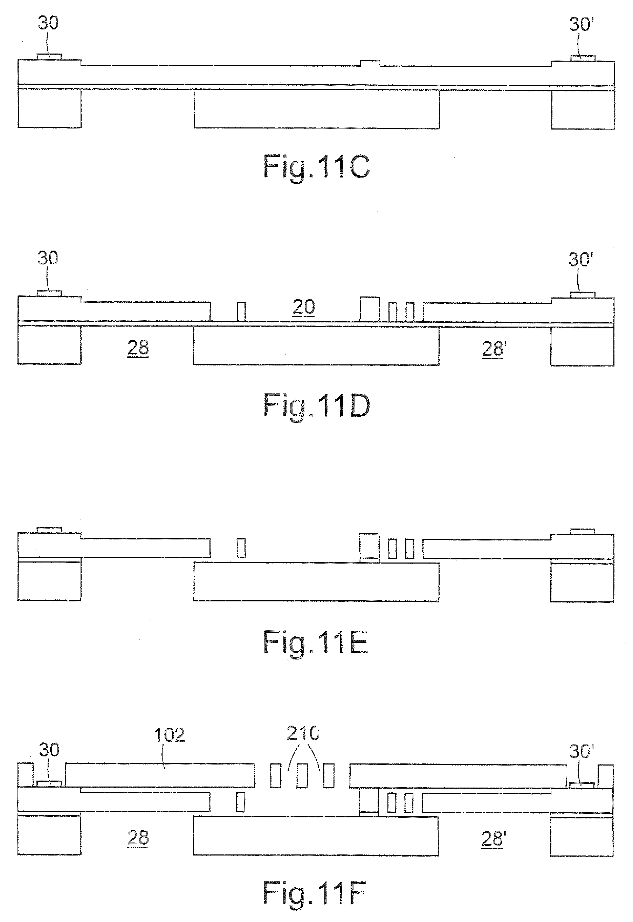

Puis un dépôt de métal (ex : Ti/Au ou AlSi,...) est réalisé, ainsi qu'une lithographie et une gravure des contacts 30, 30' (figure 11C). On peut réaliser les contacts en face arrière par la même technique.

On réalise ensuite (figure 11D) une lithographie et une gravure de la couche de silicium superficielle pour définir la cavité acoustique 20 et la structure mécanique, comportant notamment la paroi mobile ou déformable 25, l'éventuel cadre mobile et les éléments de détection (peignes capacitifs ou jauges de contrainte) dont les détails ne sont pas représentés ici : les masques de gravure utilisés sont adaptés pour réaliser les moyens adéquats en fonction du type de détection mis en oeuvre.

Ensuite on libère (figure 11E) la structure mobile par retrait de parties de la couche sacrificielle d'oxyde 103 par gravure HF (vapeur par exemple).

Enfin, on procède (figure 11F) à un collage ou à un scellement (par exemple un scellement anodique) de la structure qui vient d'être obtenue avec un substrat 102, par exemple en verre, pré-gravé, qui peut être aminci après scellement ou laminage d'un film sec (polymère, polyimide,...) et lithographie et gravure des ouvertures 210 pour mettre la cavité 20 en communication avec l'atmosphère ambiante et pour réaliser un accès aux contacts 30, 30'. En variante, une ouverture unique 21 comme en figure 2A peut aussi être réalisée.

Suivant le même déroulement, le procédé commence avec un substrat 300 standard (figure 12A), par exemple en matériau semi-conducteur tel que du silicium.

Sur ce substrat, on réalise un dépôt d'une couche sacrificielle 301 (figure 12B), une couche d'oxyde par exemple, qui, là encore dans un exemple, peut-être d'épaisseur égale à environ 0,5 µm.

Puis on dépose, sur la couche sacrificielle 301, une couche active 302 de Si-poly ou SiGe-Poly (figure 12C) dont l'épaisseur peut être, à titre d'exemple, d'environ 10 µm. On reprend ensuite le procédé précédent à partir d'une des figures 10A ou 11A.

D'une manière générale, les couches sacrificielles 103, 104 sont par exemple comprises entre quelques centaines de nm et quelques microns, par exemple entre 100 nm ou 500 nm et 1 µm ou 2 µm. Les couches actives 100, 101, 102 (chacune est par exemple en Si, ou en SiGe, ...) sont comprises entre quelques µm et quelques dizaines de µm, voire quelques centaines de µm, par exemple entre 5 µm et 10 µm ou 50 µm ou 200 µm.

L'invention offre une possibilité de meilleur contrôle technologique que les structures réalisées dans l'art antérieur, car la partie mécanique du dispositif selon invention ne met pas en oeuvre de couche mince déposée: les propriétés mécaniques de la partie mobile (la ou les membrane(s) 25) sont avant tout déterminées par la forme de cet élément, et non pas par son épaisseur, comme c'était avant tout le cas dans l'état de l'art.

Une structure selon l'invention offre en outre les avantages suivants:
- il n'y a pas de trou dans la partie mécanique sensible à la pression à mesurer (d'où une limitation des pertes acoustiques),
- possibilité d'avoir un effet piston : la pression induit alors un déplacement de toute la structure (ce qui n'est pas le cas pour une membrane encastrée).

L'invention s'applique à la réalisation de composants de type microphone ou capteur de pression dynamique, notamment pour des applications grand public (téléphonie mobile, jeux, lecteur MP3, téléviseur,...).

Dans une application particulière, un dispositif selon l'un quelconque des modes de réalisation qui à été décrit ci-dessus peut-être utilisé en combinaison avec des moyens pour récupérer une énergie acoustique. Par exemple, le circuit électrique qui comporte les plots 30, 30' est muni de moyens de stockage d'énergie électrique, par exemple une ou plusieurs batteries : l'énergie mécanique qui résulte de la déformation de la cavité déformable, et qui traduit les variations de pression de l'atmosphère ambiante, est convertie en énergie électrique (ce qui est déjà clair d'après les explications ci-dessus, puisque cette énergie permet de détecter les mouvements ou déplacements des moyens de détection), mais cette énergie électrique peut en outre être stockée.

## Revendications

1. Capteur de pression de type MEMS et/ou NEMS comportant :
- au moins une première cavité déformable (20, 20', 20", 20"') pour recevoir des variations de pression d'une atmosphère ambiante, cette première cavité déformable étant réalisée dans au moins une première couche, substantiellement plane, ou au moins un premier substrat (100), substantiellement plan, et s'étendant dans un plan xy, dit plan du capteur et comportant au moins une paroi laquelle est mobile ou déformable (25, 25', 25", 25"'); dans le plan de ladite première couche ou du premier substrat, et des moyens (21, 200, 210) pour transmettre à cette cavité des variations de pression d'une atmosphère ambiante,
- des moyens de détection (24, 24', 24₁, 24'₁, 66, 66', 64, 64' et 64₁, 64'₁) pour détecter un déplacement ou une déformation, dans le plan du capteur, de ladite paroi mobile ou déformable, sous l'effet d'une variation de pression de l'atmosphère ambiante.

2. Capteur selon la revendication 1, comportant en outre au moins une cavité secondaire (28, 28', 28", 280), ou cavité tampon, en communication avec la première cavité, pour former une cavité de référence, au moins une cavité secondaire pouvant être réalisée dans un deuxième substrat, s'étendant dans un plan parallèle au plan du capteur, ce deuxième substrat étant différent du premier substrat, ou étant réalisée dans le plan du premier substrat.

3. Capteur selon la revendication 2, ladite cavité secondaire étant réalisée dans le plan d'un deuxième substrat s'étendant dans un plan parallèle au plan du capteur :
- ce deuxième substrat (102) comportant en outre les moyens (21, 200, 210) pour transmettre à la première cavité des variations de pression de l'atmosphère ambiante,
- ou bien ce deuxième substrat (101) étant disposé d'un côté, parallèle au plan du capteur, du premier substrat, un troisième substrat (102) étant disposé d'un autre côté, parallèle au plan du capteur, du premier substrat, ce troisième substrat comportant les moyens (21, 200, 210) pour transmettre à la première cavité des variations de pression de l'atmosphère ambiante,

4. Capteur selon l'une des revendications 1 à 3, les moyens de détection comportant :
- des moyens de type capacitif, par exemple pouvant être à variation d'entrefer ou comportant au moins un premier peigne mobile dans le plan du capteur et au moins un deuxième peigne, fixe, les dents du premier peigne et celles du deuxième peigne étant alternées, et des moyens (40, 40') pour transmettre au premier peigne un déplacement ou une déformation, dans le plan du capteur, de ladite paroi mobile ou déformable,
- ou de type jauge de contrainte, par exemple comportant en outre au moins un bras de levier (66, 66') mobile dans le plan du capteur, et des moyens (40, 40') pour transmettre à ce bras de levier et à au moins une jauge de contraintes, un déplacement ou une déformation, dans le plan du capteur, de ladite paroi mobile ou déformable (25, 25'), ladite jauge de contrainte (64, 64', 64₁, 64'₁) permettant de détecter un déplacement du bras de levier dans le plan du capteur.

5. Capteur selon l'une des revendications précédentes, au moins une paroi mobile ou déformable comportant deux extrémités latérales, et :
- étant encastrée ou fixée à une de ces extrémités latérales sur une paroi fixe (23₂), et étant libre à son autre extrémité,
- ou étant encastrée ou fixée à ses deux extrémités latérales,
- ou étant rigide, et maintenue à ses deux extrémités latérales par des éléments déformables (250,253).

6. Capteur selon l'une des revendications 1 à 5, comportant une structure différentielle et/ou comportant des premiers moyens de détection et des deuxièmes moyens de détection montés de manière à réaliser une mesure différentielle.

7. Capteur selon l'une des revendications 1 à 6, les moyens (21, 200, 210) pour transmettre dans la première cavité des variations de pression d'une atmosphère ambiante comportant une ouverture unique (21) ou une pluralité d'ouvertures (210) disposée en regard d'une ouverture de ladite première cavité déformable ou une membrane (200) disposée sur une ouverture de ladite première cavité déformable.

8. Capteur selon l'une des revendications 1 à 7, les moyens de détections étant reliés mécaniquement à la paroi qui est mobile ou déformable dans le plan de la couche ou du substrat.

9. Dispositif de détection de variations de pression, comportant plusieurs premiers capteurs selon l'une des revendications précédentes, chaque capteur ayant une bande passante différente de celles des autres capteurs.

10. Dispositif de récupération d'énergie acoustique, comportant un capteur selon l'une des revendications 1 à 9, et des moyens de stockage d'énergie électrique résultant desdites variations de pression.

11. Procédé pour réaliser un capteur de pression de type MEMS et/ou NEMS comportant, dans cet ordre ou dans un autre ordre :
- la réalisation, dans au moins une première couche, substantiellement plane, ou au moins un premier substrat (100), substantiellement plan, et s'étendant dans un plan xy, dit plan du capteur, d'au moins une première cavité déformable (20, 20', 20", 20"') pour recevoir des variations de pression d'une atmosphère ambiante, cette cavité déformable étant délimitée par au moins une paroi, laquelle est mobile ou déformable (25, 25', 25", 25"') dans le plan du capteur,
- la réalisation de moyens de détection (24, 24', 24₁, 24'₁, 66, 66', 64, 64' et 64₁, 64'₁) pour détecter un déplacement ou une déformation, dans le plan du capteur, de ladite paroi mobile ou déformable, sous l'effet d'une variation de pression,
- la réalisation de moyens (21, 200,210) pour transmettre à cette cavité des variations de pression d'une atmosphère ambiante.

12. Procédé selon la revendication 11, comportant en outre la réalisation d'au moins une cavité secondaire (28,28, 28,180), ou cavité tampon, en communication avec la première cavité, pour former une cavité de référence, au moins une cavité secondaire pouvant être réalisée dans le plan d'un deuxième substrat, s'étendant dans un plan parallèle au plan du capteur, ce deuxième substrat étant différent du premier substrat, ou pouvant être réalisée dans le plan du premier substrat.

13. Procédé selon la revendication précédente, le premier substrat et le deuxième substrat étant assemblés par l'intermédiaire d'une couche diélectrique (103) pour former un substrat de type SOI.

14. Procédé selon la revendication 13, comportant un assemblage du premier substrat avec un troisième substrat, s'étendant dans un plan parallèle au plan du capteur,_pour former des moyens (21, 210), pour transmettre lesdites variations de pression à la première cavité.

15. Procédé selon l'une des revendications 11 à 14, les moyens de détection étant réalisés au moins en partie dans le premier substrat.

## Patentansprüche

1. Drucksensor vom Typ MEMS und/oder NEMS, enthaltend:
- zumindest eine erste verformbare Vertiefung (20, 20', 20", 20"`), um Druckänderungen einer Umgebungsatmosphäre aufzunehmen, wobei diese erste verformbare Vertiefung in zumindest einer ersten, im Wesentlichen flachen Schicht oder in zumindest einem ersten, im Wesentlichen flachen Substrat (100) ausgeführt ist, die/das sich in einer Ebene xy, Sensorebene genannt, erstreckt, und zumindest eine Wand aufweist, die in der Ebene der ersten Schicht bzw. des ersten Substrats beweglich bzw. verformbar ist (25, 25', 25", 25""), sowie Einrichtungen (21, 200, 210) zum Übertragen von Druckänderungen einer Umgebungsatmosphäre auf diese Vertiefung,
- Detektionseinrichtungen (24, 24', 24₁, 24'₁, 66, 66', 64, 64' und 64₁, 64'₁) zum Detektieren einer Verlagerung bzw. einer Verformung der beweglichen bzw. verformbaren Wand in der Sensorebene unter der Wirkung einer Druckänderung der Umgebungsatmosphäre.

2. Sensor nach Anspruch 1, ferner enthaltend zumindest eine Nebenvertiefung (28, 28', 28", 280) bzw. Puffervertiefung, die mit der ersten Vertiefung kommuniziert, um eine Referenzvertiefung zu bilden, wobei zumindest eine Nebenvertiefung in einem zweiten Substrat ausgeführt sein kann, das sich in einer Ebene parallel zur Sensorebene erstreckt, wobei dieses zweite Substrat sich von dem ersten Substrat unterscheidet, oder in der Ebene des ersten Substrats ausgeführt ist.

3. Sensor nach Anspruch 2, wobei die Nebenvertiefung in der Ebene eines zweiten Substrats ausgeführt ist, das sich in einer Ebene parallel zur Sensorebene erstreckt:
- wobei dieses zweite Substrat (102) ferner Einrichtungen (21, 200, 210) zum Übertragen von Druckänderungen der Umgebungsatmosphäre auf die erste Vertiefung aufweist,
- oder aber dieses zweite Substrat (101) auf einer parallel zur Sensorebene verlaufenden Seite des ersten Substrats angeordnet ist, wobei ein drittes Substrat (102) auf einer anderen, parallel zur Sensorebene verlaufenden Seite des ersten Substrats angeordnet ist, wobei dieses dritte Substrat Einrichtungen (21, 200, 210) zum Übertragen von Druckänderungen der Umgebungsatmosphäre auf die erste Vertiefung enthält.

4. Sensor nach einem der Ansprüche 1 bis 3, wobei die Detektionseinrichtungen enthalten:
- kapazitiv ausgeführte Einrichtungen, die beispielsweise mit Luftspaltänderung ausgeführt sein können oder zumindest einen in der Sensorebene beweglichen ersten Kamm und zumindest einen festen zweiten Kamm enthalten, wobei die Zähne des ersten Kamms und die des zweiten Kamms abwechselnd vorgesehen sind, sowie Einrichtungen (40, 40') zum Übertragen einer Verlagerung oder einer Verformung der beweglichen oder verformbaren Wand in der Sensorebene auf den ersten Kamm,
- oder als Dehnungsmessstreifen ausgeführte Einrichtungen, die beispielweise ferner zumindest einen Hebelarm (66, 66') enthalten, der in der Sensorebene beweglich ist, sowie Einrichtungen (40, 40') zum Übertragen einer Verlagerung oder einer Verformung der beweglichen bzw. verformbaren Wand (5, 25') in der Sensorebene auf diesen Hebelarm und auf zumindest einen Dehnungsmessstreifen, wobei der Dehnungsmessstreifen (64, 64', 64₁, 64'₁) gestattet, eine Verlagerung des Hebelarms in der Sensorebene zu detektieren.

5. Sensor nach einem der vorangehenden Ansprüche, wobei zumindest eine bewegliche bzw. verformbare Wand zwei seitliche Enden aufweist und
- mit einem dieser seitlichen Enden an einer festen Wand (23₂) verbaut bzw. befestigt ist und mit ihrem anderen Ende frei liegt,
- oder mit ihren beiden seitlichen Enden verbaut bzw. befestigt ist,
- oder starr ausgeführt ist und mit ihren beiden seitlichen Enden über verformbare Elemente (250, 251) festgehalten wird.

6. Sensor nach einem der Ansprüche 1 bis 5, enthaltend eine Differenzstruktur und/oder erste Detektionseinrichtungen und zweite Detektionseinrichtungen, die so geschaltet sind, dass sie eine Differenzmessung durchführen.

7. Sensor nach einem der Ansprüche 1 bis 6, wobei die Einrichtungen (21, 200, 210) zum Übertragen von Druckänderungen einer Umgebungsatmosphäre in die erste Vertiefung eine einzige Öffnung (21) bzw. eine Mehrzahl von Öffnungen (210) aufweisen, die einer Öffnung der verformbaren ersten Vertiefung gegenüberliegt, oder eine Membran (200) aufweisen, die an einer Öffnung der verformbaren ersten Vertiefung angeordnet ist.

8. Sensor nach einem der Ansprüche 1 bis 7, wobei die Detektionseinrichtungen mechanisch mit der Wand verbunden sind, die in der Ebene der Schicht bzw. des Substrats beweglich bzw. verformbar ist.

9. Detektionsvorrichtung zum Detektieren von Druckänderungen, enthaltend mehrere erste Sensoren nach einem der vorangehenden Ansprüche, wobei jeder Sensor ein Durchlassband hat, das sich von dem der weiteren Sensoren unterscheidet.

10. Vorrichtung zur Rückgewinnung von Schallenergie, enthaltend einen Sensor nach einem der Ansprüche 1 bis 9 und Einrichtungen zum Speichern von elektrischer Energie, die sich aus den Druckänderungen ergibt.

11. Verfahren zum Herstellen eines Drucksensors vom Typ MEMS und/oder NEMS, umfassend in dieser oder in einer anderen Reihenfolge:
- Einbringen von zumindest einer ersten verformbaren Vertiefung (20, 20', 20", 20"`) in zumindest eine erste, im Wesentlichen flache Schicht oder in zumindest ein erstes, im Wesentlichen flaches Substrat (100), die/das sich in einer Ebene xy erstreckt, Sensorebene genannt, erstreckt, um Druckänderungen einer Umgebungsatmosphäre aufzunehmen, wobei diese verformbare Vertiefung von zumindest einer Wand begrenzt wird, die in der Sensorebene beweglich bzw. verformbar ist (25, 25', 25", 25"'),
- Bereitstellen von Detektionseinrichtungen (24, 24', 24₁, 24'₁, 66, 66', 64, 64' und 64₁, 64'₁) zum Detektieren einer Verlagerung bzw. einer Verformung der beweglichen bzw. verformbaren Wand in der Sensorebene unter der Wirkung einer Druckänderung,
- Bereitstellen von Einrichtungen (21, 200, 210) zum Übertragen von Druckänderungen einer Umgebungsatmosphäre auf diese Vertiefung.

12. Verfahren nach Anspruch 11, ferner umfassend das Bereitstellen von zumindest einer Nebenvertiefung (28,28, 28,180) bzw. Puffervertiefung, die mit der ersten Vertiefung kommuniziert, um eine Referenzvertiefung zu bilden, wobei zumindest eine Nebenvertiefung in der Ebene eines zweiten Substrats ausgeführt sein kann, das sich in einer Ebene parallel zur Sensorebene erstreckt, wobei dieses zweite Substrat sich von dem ersten Substrat unterscheidet, oder in der Ebene des ersten Substrats ausgeführt sein kann.

13. Verfahren nach dem vorangehenden Anspruch, wobei das erste Substrat und das zweite Substrat über eine dielektrische Schicht (103) zusammengefügt sind, um eine Substrat vom Typ SOI zu bilden.

14. Verfahren nach Anspruch 13, umfassend ein Zusammenfügen des ersten Substrats mit einem dritten Substrat, das sich in einer Ebene parallel zur Sensorebene erstreckt, um Einrichtungen (21, 210) zum Übertragen der Druckänderungen auf die erste Vertiefung zu bilden.

15. Verfahren nach zumindest einem der Ansprüche 11 bis 14, wobei die Detektionseinrichtungen zumindest teilweise in dem ersten Substrat ausgeführt sind.

## Claims

1. A pressure sensor of the MEMS and/or NEMS type, including:
- at least one first deformable cavity (20, 20', 20", 20"') to receive pressure variations from an ambient atmosphere, this first deformable cavity being made in at least a first substantially planar layer or in at least a first substantially planar substrate (100), extending in a plane xy, called sensor plane, and including at least one wall (25, 25', 25", 25"'), which is mobile or deformable in the plane of said first layer or of said first substrate, and a means (21, 200, 210) for transmitting pressure variations from an ambient atmosphere to said cavity,
- a detection means (24, 24', 24₁, 24'₁, 66, 66', 64, 64' and 64₁, 64'₁) for detecting a displacement or deformation, in the plane of the sensor, of said mobile or deformable wall, under the effect of a pressure variation of the ambient atmosphere.

2. The sensor according to claim 1, also having at least one secondary cavity (28, 28', 28", 280), or buffer cavity, partially in communication with the first cavity, said secondary or buffer cavity forming a reference cavity, at least one secondary cavity being possibly made in a second substrate, extending in a plane parallel to said sensor plane, said second substrate being different from the first substrate, or being made in the plane of the first substrate.

3. The sensor according to claim 2, at least one secondary cavity being made in a second substrate, extending in a plane parallel to said sensor plane:
- said second substrate (102) also including the means (21, 200, 210) for transmitting pressure variations of the ambient atmosphere to the first cavity,
- or said second substrate (101) being arranged on a side, parallel to said sensor plane, of the first substrate, a third substrate (102) being arranged on another side, extending in a plane parallel to said sensor plane, of the first substrate, said third substrate including the means (21, 200, 210) to transmit pressure variations from the ambient atmosphere to the first cavity.

4. The sensor according to one of claims 1 to 3, the detection means including:
- capacitive means, being for example with air gap variation or having at least one comb able to move in the plane of the sensor and at least one second comb, stationary, the teeth of the first comb and those of the second comb alternating, and a means (40, 40') for transmitting a displacement or deformation to the first comb, in the plane of the sensor, of said mobile or deformable wall.
- or being of the strain gauge type, for example also having a lever arm (66, 66') able to move in the plane of the sensor, and a means (40, 40') for transmitting, to said lever arm and at least one strain gauge, a displacement or deformation, in the plane of the sensor, of said mobile or deformable wall (25, 25'), said strain gauge (64, 64', 64₁, 64'₁) making it possible to detect a displacement of the lever arm in the plane of the sensor.

5. The sensor according to one of the preceding claims, at least one mobile or deformable wall including two lateral ends, and:
- being embedded or fastened at one of these lateral ends on a stationary wall (23₂), and being free at its other end,
- or being embedded or fastened at both of its lateral ends,
- or being rigid, and maintained at both of its lateral ends by deformable elements (250, 251).

6. The sensor according to one of claims 1 to 5, having a differential structure and/or having a first detection means and a second detection means mounted so as to perform a differential measurement.

7. The sensor according to one of claims 1 to 6, the means (21, 200, 210) for transmitting, in the first cavity, pressure variations from an ambient atmosphere having a single opening (21) or several openings (210) arranged opposite an opening of said first deformable cavity and a membrane (200) arranged on an opening of said first deformable cavity.

8. The sensor according to any of claims 1 to 7, said detection means being mechanically connected to said mobile or deformable wall.

9. A device for detecting pressure variations, including several sensors according to one of the preceding claims, each sensor having a bandwidth different from those of each of the other sensors.

10. A device for recovering acoustic energy, including a sensor according to one of claims 1 to 9, and a means for storing electrical energy resulting from said pressure variations.

11. A method for producing a MEMS and/or NEMS pressure sensor including, in this order or another order:
- the production, in at least a first substantially planar layer or in at least a first substantially planar substrate (100), extending in a plane xy, called sensor plane, of at least one first deformable cavity (20, 20', 20", 20"') for receiving pressure variations from an ambient atmosphere, this deformable cavity being delimited by at least one wall (25, 25', 25", 25"'), which is mobile or deformable mobile in said sensor plane,
- the production of a detection means (24, 24', 24₁, 24'₁, 66, 66', 64, 64' et 64₁, 64'₁) for detecting a displacement or a deformation, in said sensor plane, of said wall, under the effect of a pressure variation,
- the production of a means (21, 200, 210) for transmitting pressure pulses from an ambient atmosphere to said cavity.

12. The method according to claim 11, also including the production of at least one secondary cavity (28, 28, 28, 180), or buffer cavity, communicating with the first cavity, said secondary or buffer cavity forming a reference cavity, at least one secondary cavity being possibly made in the plane of a second substrate, extending in a plane parallel to said sensor plane, said second substrate being different from the first substrate, or being made in the plane of the first substrate.

13. The method according to the preceding claim, the first substrate and the second substrate being assembled via a dielectric layer (103) to form a SOI substrate.

14. The method according to claim 13, having an assembly of the first substrate with a third substrate, extending in a plane parallel to said sensor plane, to form a means (21, 210) for transmitting said pressure variations to the first cavity.

15. The method according to one of claims 11 to 14, the detection means being made at least partially in the first substrate.
